# EUROPEAN PATENT APPLICATION

(11) **EP 4 827 246 A1**
(43) Date of publication of application: **21.10.2026**
(21) Application number: 24904274.8
(22) Date of filing: 13.12.2024
(51) Int. Cl.: H05K 1/02, H05K 3/28, H05K 1/18, H05K 3/18, H05K 1/11, G06F 3/041, H05K 1/14

(54) **FLEXIBLE CIRCUIT BOARD, COF MODULE, AND ELECTRONIC DEVICE COMPRISING SAME**

(30) Priority: 14.12.2023 KR 20230181896; 02.09.2024 KR 20240118467
(71) Applicant: LG Innotek Co., Ltd., Seoul 07796 (KR)
(72) Inventor: LEE, Sang Kyu, Seoul 07796 (KR); CHAE, Sung Min, Seoul 07796 (KR); PARK, Ji Hyo, Seoul 07796 (KR); JEON, Se Mi Na, Seoul 07796 (KR)
(74) Representative: DREISS Patentanwälte PartG mbB
(86) International application number: PCT/KR2024/020302
(87) International publication number: WO 2025/127709

(57) **Abstract**

A flexible circuit board according to an embodiment comprises a substrate; an upper wiring pattern disposed on the substrate; an upper protective layer disposed on the upper wiring pattern and including an open region; a lower wiring pattern disposed under the substrate; and a lower protective layer disposed under the lower wiring pattern, wherein the upper wiring pattern includes a first overlapping region overlapping the upper protective layer along a thickness direction of the substrate, wherein the lower wiring pattern includes a second overlapping region overlapping the lower protective layer along the thickness direction of the substrate, and wherein a metal content of the upper wiring pattern in the first overlapping region is different from a metal content of the lower wiring pattern in the second overlapping region.

## Description

### Technical Field

An embodiment relates to a flexible circuit board, a COF module and an electronic device including the same.

### Background Art

Recently, various electronic products are becoming thinner and smaller. Accordingly, it is required to mount semiconductor chips in a narrow region of the electronic product at a high density.

A COF (Chip On Film) includes a circuit board and a chip disposed on the circuit board. The circuit board is flexible. That is, the COF is a flexible circuit board. Accordingly, the COF is applied to a flexible display. For example, the COF can be applied to various wearable electronic devices. In addition, the COF has a fine pitch. Accordingly, the COF is applied to a display having a high resolution.

The chip includes a semiconductor chip. For example, the chip can be an integrated circuit (IC) chip or a large scale integrated circuit (LSI) chip.

The chip is connected to an external circuit board and a display panel through a circuit pattern. For example, pad portions are provided at each one end and other end of the circuit pattern. Either pad portion is electrically connected to a terminal of the chip. Another pad portion is connected to terminals of the external circuit board and the display panel. Accordingly, the chip, the external circuit board, and the display panel are electrically connected through the COF. Accordingly, a signal is transmitted to the display panel through the circuit pattern.

The flexible circuit board may have circuit patterns disposed on both surfaces of the substrate. In this case, a protective layer is disposed on each of the two surfaces of the substrate. The circuit pattern may be prevented from corrosion by the protective layer.

However, the flexible circuit board has a problem in that cracks may occur during a process of repeatedly bending the circuit pattern formed on the flexible circuit board or combining it with a display panel and/or an external circuit board in a bent state, or the flexible circuit board may be damaged due to tensile force generated during the bending process.

### Disclosure

### Technical Problem

The embodiment provides a flexible circuit board capable of solving electrical reliability and/or physical reliability problems that occur during bending of a flexible circuit board, a COF module, and an electronic device including the same.

In addition, the embodiment provides a flexible circuit board capable of being slimmed down, a COF module, and an electronic device including the same.

In addition, the embodiment provides a flexible circuit board with improved bending durability of a circuit pattern, a COF module, and an electronic device including the same.

Technical problems to be solved by the proposed embodiments are not limited to the above-mentioned technical problems, and other technical problems not mentioned may be clearly understood by those skilled in the art to which the embodiments proposed from the following descriptions belong.

### Technical Solution

A flexible circuit board according to an embodiment comprises a substrate; an upper wiring pattern disposed on the substrate; an upper protective layer disposed on the upper wiring pattern and including an open region; a lower wiring pattern disposed under the substrate; and a lower protective layer disposed under the lower wiring pattern, wherein the upper wiring pattern includes a first overlapping region overlapping the upper protective layer along a thickness direction of the substrate, wherein the lower wiring pattern includes a second overlapping region overlapping the lower protective layer along the thickness direction of the substrate, and wherein a metal content of the upper wiring pattern in the first overlapping region is different from a metal content of the lower wiring pattern in the second overlapping region.

In addition, the first overlapping region includes a region in which a content of a metal constituting the upper wiring pattern changes as it approaches the upper protective layer, and the second overlapping region does not include a region in which a content of a metal constituting the lower wiring pattern changes.

In addition, an amount of change in the content of the metal constituting the upper wiring pattern in the first overlapping region as the upper wiring pattern approaches the upper protective layer is greater than an amount of change in the content of the metal constituting the lower wiring pattern in the second overlapping region as the lower wiring pattern approaches the lower protective layer.

In addition, the upper wiring pattern includes an upper wiring layer disposed on the substrate, a first upper plating layer disposed on the upper wiring layer; and a second upper plating layer disposed on the first upper plating layer within the open region, the lower wiring pattern includes a lower wiring layer disposed under the substrate, the upper protective layer is in direct contact with the first upper plating layer in the first overlapping region, and the lower protective layer is in direct contact with the lower wiring layer in the second overlapping region.

In addition, the first upper plating layer includes an open portion overlapping at least a portion of the upper wiring layer along the thickness direction, and the upper protective layer includes a first protective pattern disposed in the open portion of the first upper plating layer, and a second protective pattern disposed on the first upper plating layer and the first protective pattern.

In addition, the upper protective layer includes a first open region positioned between a first side end and a second side end of the substrate, and a second open region spaced from the first open region and closer to the first side end than the first open region, and the open portion of the first upper plating layer is closer to the second side end of the substrate than the first open region and the second open region.

In addition, the lower protective layer includes a third open region closer to the second side end of the substrate than the first open region and the second open region, and the lower wiring pattern further includes a first lower plating layer disposed under the lower wiring layer in the third open region, and a second lower plating layer disposed under the first lower plating layer.

In addition, the upper protective layer includes a third open region closer to the second side end of the substrate than the first open region and the second open region, the lower protective layer does not include an open region, and the lower surface of the lower wiring layer of the lower wiring pattern is in direct contact with the lower protective layer as a whole.

In addition, the flexible circuit board further comprises a first via electrode penetrating the substrate along the thickness direction at a position adjacent to the first open region and connecting the upper wiring pattern and the lower wiring pattern; and a second via electrode penetrating the substrate along the thickness direction at a position adjacent to the third open region and connecting the upper wiring pattern and the lower wiring pattern, and the open portion of the first upper plating layer is provided to extend in a direction different from a separation direction of the first via electrode and the second via electrode between the first via electrode and the second via electrode.

In addition, the lower wiring pattern does not overlap with a region between the first open region and the second open region along the thickness direction.

In addition, the flexible circuit board further comprises a lower dummy pattern disposed under the substrate and overlapping the region between the first open region and the second open region along the thickness direction.

### Advantageous Effects

The flexible circuit board of the embodiment includes a substrate, an upper wiring pattern, a lower wiring pattern, an upper protective layer, and a lower protective layer. The substrate includes a first region corresponding to a bending region, and a second region excluding the first region. In addition, the upper wiring pattern includes an upper wiring layer, a first upper plating layer, and a second upper plating layer. At this time, the first and second upper plating layers may not be disposed in the first region of the flexible circuit board of the embodiment. Accordingly, the embodiment can prevent cracks occurring during bending of the flexible circuit board in the first region, thereby further improving physical reliability and/or electrical reliability of the flexible circuit board. In addition, the embodiment can prevent damage to the upper wiring pattern due to tensile force of the upper wiring pattern occurring during bending of the flexible circuit board in the first region, thereby improving durability of the upper wiring pattern.

In addition, a second protective pattern of the upper protective layer may be provided on the first upper plating layer to surround the first protective pattern of the upper protective layer provided in the open portion of the first upper plating layer.

That is, the first protective pattern of the upper protective layer may be in contact with the upper wiring layer and the first upper plating layer. The first protective pattern may be in contact with the upper surface of the upper wiring layer on the first region and a side surface of the first upper plating layer. That is, the first protective pattern is in direct contact with the upper wiring layer, and thus, stress that may occur during bending in the first region may be dispersed, and thus, physical reliability and/or electrical reliability of the flexible circuit board may be further improved. In addition, a lower surface of the second protective pattern is in contact with the first upper plating layer and does not contact the second upper plating layer. Accordingly, a thickness of the flexible circuit board may be prevented from increasing by a thickness of the second upper plating layer.

In addition, the lower wiring pattern includes a lower wiring layer, a first lower plating layer, and a second lower plating layer. At this time, the lower protective layer includes a third open region. In addition, the first lower plating layer and the second lower plating layer of the lower wiring pattern are disposed only in the third open region of the lower protective layer. That is, the first lower plating layer and the second lower plating layer may not be disposed between the lower wiring layer and the lower protective layer.

Specifically, the first lower plating layer and the second lower plating layer may not be disposed between the lower wiring layer and the lower protective layer. For example, an upper surface of the lower protective layer may not contact the first lower plating layer and the second lower plating layer. The first lower plating layer and the second lower plating layer may be selectively disposed only in the third open region of the lower protective layer.

That is, the embodiment prevents the lower plating layer from being disposed between the lower wiring layer and the lower protective layer. Accordingly, the embodiment can prevent the bending characteristics of the flexible circuit board from being deteriorated by the lower plating layer. Furthermore, the embodiment can prevent the occurrence of cracks in the lower wiring pattern by the lower plating layer when the flexible circuit board is bent. Therefore, the embodiment can further improve the durability of the lower wiring pattern.

In addition, a via electrode is disposed in the substrate to connect the upper wiring pattern and the lower wiring pattern. The via electrode includes a first via electrode overlapping the first open region along the thickness direction. In addition, the via electrode includes a second via electrode adjacent to one side end of the substrate from the first open region. In addition, the embodiment provides a first region between the first via electrode and the second via electrode. Preferably, the first region can extend in a direction perpendicular to a separation direction of the first via electrode and the second via electrode between the first via electrode and the second via electrode. Through this, the embodiment can improve the rigidity of the flexible circuit board by the first via electrode and the second via electrode when the flexible circuit board is bent in the first region, thereby further improving the physical reliability and/or electrical reliability of the flexible circuit board.

In addition, the lower wiring pattern may not be disposed in a region of the second surface of the substrate. Preferably, the lower wiring pattern may not overlap with a region between the first open region and the second open region of the upper protective layer in the thickness direction. Preferably, the lower wiring pattern may not be disposed in a region of the second surface of the substrate that overlaps in the thickness direction with the region between the first open region and the second open region of the upper protective layer, and may be provided in a region of the second surface of the substrate that does not overlap in the thickness direction with the region between the first open region and the second open region of the upper protective layer. Through this, the embodiment can control an arrangement region of the lower wiring pattern to control the tensile force of the lower wiring pattern that occurs when the flexible circuit board is bent, thereby further improving the durability of the lower wiring pattern.

The flexible circuit board according to the embodiment is bent at least twice. Accordingly, a bezel region of the display panel is prevented from increasing by the flexible circuit board.

In addition, the flexible circuit board includes a plurality of open regions. A bonding layer is not disposed on the open regions. The flexible circuit board is bent in the open regions. Accordingly, when the flexible circuit board is bent, the bonding layer can be prevented from being delaminated.

The protective layer can include at least one protective pattern. For example, the protective layer can include a plurality of protective patterns. Accordingly, a plurality of protective patterns are disposed on the open regions. Accordingly, when the flexible circuit board is bent, the protective layer can be prevented from being delaminated.

### Description of Drawings

FIG. 1 is a top view of a flexible circuit board according to an embodiment.
FIG. 2 is a bottom view of a flexible circuit board according to an embodiment.
FIG. 3 is a view showing an enlarged view of region A of FIG. 1.
FIG. 4 is a view showing an enlarged view of region B of FIG. 1.
FIG. 5 is a view showing an enlarged view of region C of FIG. 2.
FIG. 6 is a view showing an enlarged view of region D of FIG. 2.
FIG. 7 is a cross-sectional view of a flexible circuit board according to a first embodiment taken along line A-A' of FIG. 1.
FIG. 8 is a cross-sectional view of a flexible circuit board according to a second embodiment taken along line A-A' of FIG. 1.
FIG. 9 is a cross-sectional view of a flexible circuit board according to the third embodiment taken along line A-A' of FIG. 1.
FIG. 10 is a cross-sectional view of a flexible circuit board according to a fourth embodiment taken along line A-A' of FIG. 1.
FIG. 11 is a top view of a flexible circuit board according to a fifth embodiment.
FIG. 12 is a bottom view of a flexible circuit board according to a fifth embodiment.
FIG. 13 is a view showing an enlarged view of region E of FIG. 11.
FIG. 14 is a view showing an enlarged view of region F of FIG. 11.
FIGS. 15 and 16 are views for explaining a shape of a COF module being bent.
FIGS. 17 and 18 are views for explaining a shape of a COF module being bent according to an embodiment.
FIGS. 19 and 20 are cross-sectional views taken along line A-A' of FIG. 3 according to a fifth embodiment.
FIGS. 21 and 22 are cross-sectional views taken along line B-B' of FIG. 12.
FIG. 23 is a view for explaining positions of protective layers according to a fifth embodiment.
FIG. 24 and FIG. 25 are cross-sectional views taken along region B-B' of FIG. 12.
FIG. 26 to FIG. 29 are views illustrating various shapes in which a COF module including a flexible circuit board according to an embodiment is bent.
FIG. 30 to FIG. 32 are views regarding an electronic device including a flexible circuit board according to an embodiment.

### Modes of the Invention

Hereinafter, embodiments of the present invention will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and redisposed.

In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

In addition, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", or "coupled" to another element, it may include not only when the element is directly "connected" to, or "coupled" to other elements, but also when the element is "connected", or "coupled" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

In addition, in the following description, a first direction 1D may be defined as a width direction of the flexible circuit board, and a second direction 2D may be defined as a length direction of the flexible circuit board.

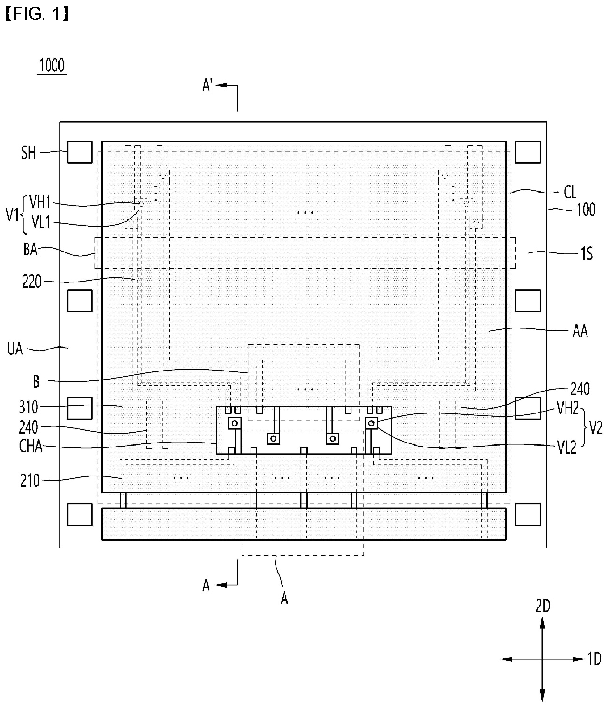

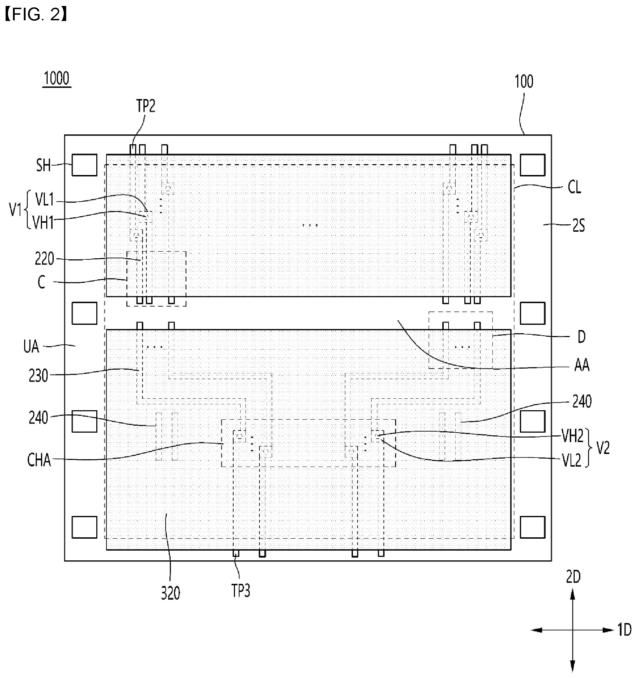

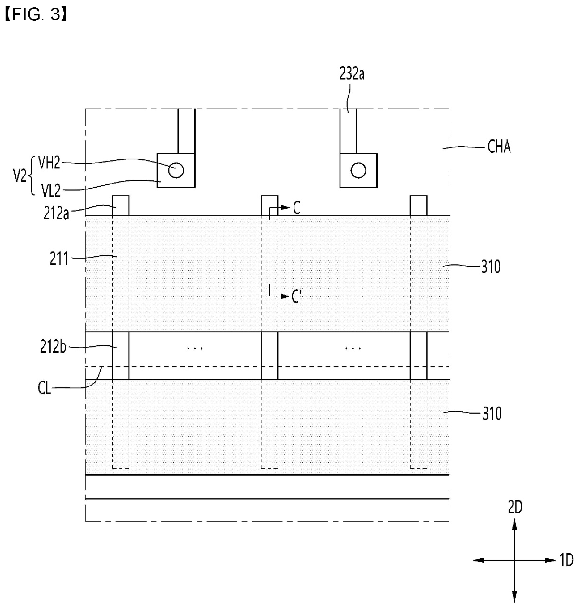

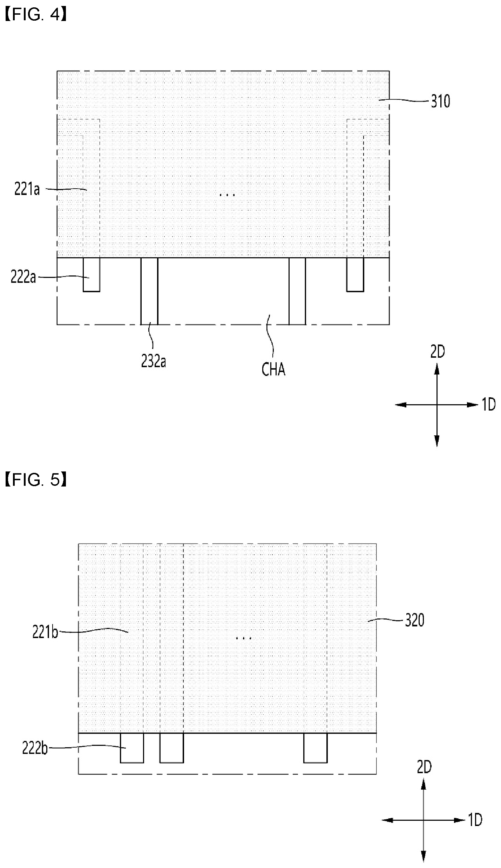

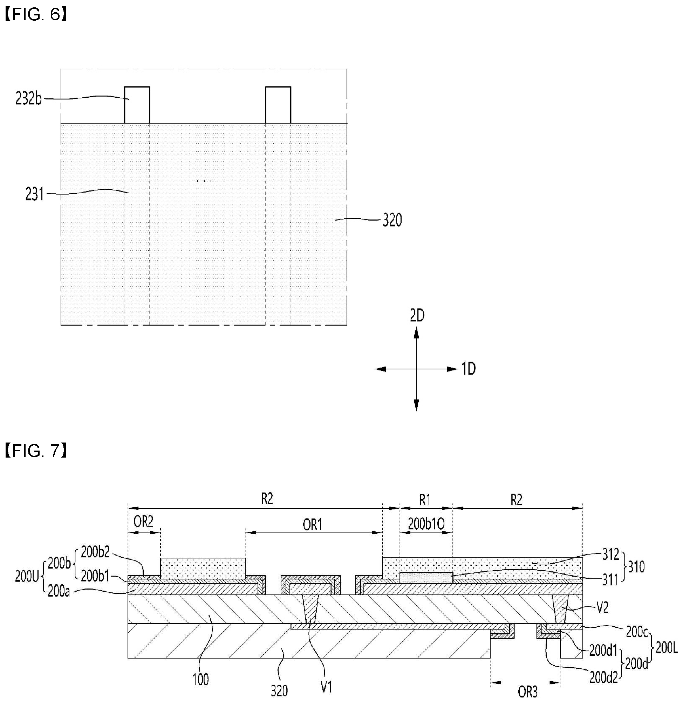

FIG. 1 is a top view of a flexible circuit board according to an embodiment, FIG. 2 is a bottom view of a flexible circuit board according to an embodiment, FIG. 3 is a view showing an enlarged view of region A of FIG. 1, FIG. 4 is a view showing an enlarged view of region B of FIG. 1, FIG. 5 is a view showing an enlarged view of region C of FIG. 2, and FIG. 6 is a view showing an enlarged view of region D of FIG. 2.

Hereinafter, a flexible circuit board according to an embodiment will be described with reference to FIGS. 1 to 6.

A flexible circuit board 1000 according to an embodiment includes a substrate 100, a wiring pattern part, and a protective layer.

The substrate 100 includes a first surface 1S and a second surface 2S opposite to the first surface 1S. In addition, a wiring pattern part and a protective layer are disposed on the first surface 1S and the second surface 2S of the substrate 100. That is, the wiring pattern part includes a first wiring pattern part or upper wiring pattern part disposed on the first surface 1S of the substrate 100. In addition, the wiring pattern part includes a second wiring pattern part or lower wiring pattern part disposed on the second surface 2S of the substrate 100. In addition, the protective layer includes a first protective layer disposed on the first surface 1S of the substrate 100 and covering at least a portion of the first or upper wiring pattern part. In addition, the protective layer includes a second protective layer disposed on the second surface 2S of the substrate 100 and covering at least a portion of the second or lower wiring pattern part. In other words, the wiring pattern part and the protective layer are disposed on the first surface 1S and the second surface 2S. Accordingly, the flexible circuit board 1000 of the embodiment may be a double-sided flexible circuit board.

The substrate 100 includes a cutting line CL. The flexible circuit board 1000 is cut along the cutting line CL. In detail, a wiring pattern part, a protective layer, and a chip are disposed on the substrate 100. Then, the substrate 100 is cut along the cutting line CL. Accordingly, the COF module 2000 is manufactured. Accordingly, the cutting line CL becomes an end of the flexible circuit board 1000 and the COF module 2000.

The substrate 100 may include an effective region AA and an ineffective region UA. The effective region AA and the ineffective region UA are separated by the cutting line CL. The effective region AA is an inner region of the cutting line CL. The ineffective region UA is an outer region of the cutting line CL.

A wiring pattern part, a protective layer, and a chip are disposed in the effective region AA. A dummy pattern and a sprocket hole SH are disposed in the ineffective region UA. The dummy pattern can increase a rigidity of the substrate 100. This prevents the flexible circuit board 1000 from being bent. The flexible circuit board 1000 is rolled or unrolled in a roll-to-roll manner by the sprocket hole SH.

The substrate 100 includes a chip mounting region CHA. The chip mounting region CHA is disposed in the effective region AA. The chip is disposed on the chip mounting region CHA. Pads of the wiring pattern part are disposed inside the chip mounting region CHA. The protective layer is not disposed on the chip mounting region CHA.

The substrate 100 may include a flexible material. For example, the substrate 100 may include polyimide (PI). However, the embodiment is not limited thereto. The substrate 100 may include a polymer material such as polyethylene terephthalate (PET) or polyethylene naphthalate (PEN).

The substrate 100 may have a thickness of 20 µm to 100 µm. For example, the substrate 100 may have a thickness of 25 µm to 50 µm. For example, the substrate 100 may have a thickness of 30 µm to 40 µm. If the thickness of the substrate 100 exceeds 100 µm, the thickness of the flexible circuit board increases. Therefore, the flexible characteristics of the flexible circuit board may deteriorate. If the thickness of the substrate 100 is less than 20 µm, the flexible circuit board 1000 may be damaged. That is, the chip is mounted using heat and pressure. Accordingly, if the thickness of the substrate 100 is less than 20 µm, the substrate 100 may be damaged by heat and pressure.

The wiring pattern part and the protective layer are disposed on the substrate 100. In detail, the wiring pattern part and the protective layer may be disposed on the effective region AA and the ineffective region UA.

The wiring pattern part may include a first wiring pattern 210, a second wiring pattern 220, and a third wiring pattern 230. The protective layer may include a first protective layer 310 and a second protective layer 320. The first wiring pattern 210 and the third wiring pattern 230 of the wiring pattern part may be a first wiring pattern part or an upper wiring pattern part disposed on the first surface 1S of the substrate 100. In addition, a part of the second wiring pattern 220 of the wiring pattern part may be a first wiring pattern part or an upper wiring pattern part disposed on the first surface 1S of the substrate 100, and another part of the second wiring pattern 220 may be a second wiring pattern part or a lower wiring pattern part disposed on the second surface 2S of the substrate 100.

Referring to FIG. 1 and FIG. 3, the first wiring pattern 210 is disposed on the first surface 1S. The first wiring pattern 210 includes a first connection wiring 211, a first pad 212a, and a second pad 212b. The first connection wiring 211, the first pad 212a, and the second pad 212b may include a same material. The first connection wiring 211, the first pad 212a, and the second pad 212b may be formed integrally.

The first pad 212a is disposed inside the chip mounting region CHA. Accordingly, the first pad 212a is connected to a terminal of the chip. Accordingly, the first wiring pattern 210 and the chip are connected.

The second pad 212b is disposed outside the chip mounting region CHA. The second pad 212b is connected to a terminal of an external circuit board. Accordingly, the first wiring pattern 210 and the circuit board are connected. In addition, the second pad 212b may be a first test pad. In detail, before connecting the circuit board and the second pad 212b, the flexible circuit board 1000 may be tested. For example, the second pad 212b can be used to check whether the first wiring pattern 210 is open or shorted.

The first connection wiring 211 is disposed between the first pad 212a and the second pad 212b. The first connection wiring 211 electrically connects the first pad 212a and the second pad 212b. Accordingly, the chip and the flexible circuit board 1000 are connected. Accordingly, a signal generated from the chip is transmitted to the flexible circuit board 1000.

A first protective layer 310 is disposed on the first wiring pattern 210. The first protective layer 310 is disposed on the first connection wiring 211. The first protective layer 310 is not disposed on the first pad 212a and the second pad 212b. That is, the first protective layer 310 may include a plurality of open regions. For example, the first protective layer 310 may include a first open region OR1 that overlaps the first pad 212a disposed in the chip mounting region CHA along a thickness direction. In addition, the first protective layer 310 may include a second open region OR2 that overlaps the second pad 212b along the thickness direction. That is, the substrate 100 may include a first side end and a second side end opposite to the first side end. In addition, the first open region OR1 may be located between the first side end and the second side end. In addition, the second open region OR2 may be spaced apart from the first open region OR1 and may be located closer to the first side end than the first open region OR1.

In addition, referring to FIGS. 1, 2, 4, and 5, the second wiring pattern 220 is disposed on the first surface 1S and the second surface 2S. That is, the second wiring pattern 220 may include an upper wiring pattern disposed on the first surface 1S of the substrate 100, and a lower wiring pattern disposed on the second surface 2S of the substrate 100.

The second wiring pattern 220 includes a second connection wiring 221a and 221b, a third pad 222a, a fourth pad 222b, and a first via electrode V1. The second connection wiring 221a and 221b, the third pad 222a, and the fourth pad 222b may include a same material. In addition, the second connection wiring 221a and 221b, the third pad 222a, and the fourth pad 222b may be formed integrally.

A first protective layer 310 and a second protective layer 320 are disposed on the second connection wiring 221a and 221b. The first protective layer 310 and the second protective layer 320 are not disposed on the third pad 222a and the fourth pad 222b. That is, the first open region of the first protective layer 310 may further expose the third pad 222a.

The third pad 222a is disposed on the first surface 1S. The third pad 222a is disposed inside the chip mounting region CHA. Accordingly, the third pad 222a is connected to a terminal of the chip. Accordingly, the second wiring pattern 220 and the chip are connected.

The fourth pad 222b is disposed on the second surface 2S. The fourth pad 222b is connected to a terminal of the external display panel. Accordingly, the second wiring pattern 220 and the display panel are connected.

The second connection wiring 221a and 221b includes a second-first connection wiring 221a and a second-second connection wiring 221b. The second-first connection wiring 221a is disposed on the first surface 1S. The second-second connection wiring 221b is disposed on the second surface 2S. The second connection wiring 221a and 221b connects the third pad 222a and the fourth pad 222b. In detail, the second-first connection wiring 221a is connected to the third pad 222a. The second-second connection wiring 221b is connected to the fourth pad 222b. Accordingly, the chip and the display panel are connected. Accordingly, a signal generated from the chip is transmitted to the display panel.

A first protective layer 310 and a second protective layer 320 are disposed on the second wiring pattern 220. In detail, the first protective layer 310 is disposed on the second wiring pattern 220 on the first surface 1S. The second protective layer 320 is disposed on the second wiring pattern 220 on the second surface 2S. The first protective layer 310 and the second protective layer 320 are not disposed on the third pad 222a and the fourth pad 222b.

The second-first connection wiring 221a and the second-second connection wiring 221b are electrically connected to each other. The second-first connection wiring 221a and the second-second connection wiring 221b are electrically connected through a first via electrode V1. The first via electrode V1 penetrates the first surface 1S and the second surface 2S of the substrate 100. Accordingly, the first via electrode V1 is disposed on the first surface 1S and the second surface 2S. A via land of the first via electrode V1 on the first surface 1S and a via land of the first via electrode V1 on the second surface 2S are disposed at positions corresponding to each other.

The first via electrode V1 includes a first via land VL1 and a first through portion VH1. The first through portion VH1 is formed inside the first via land VL1. The first via land VL1 includes a same material as the second connection wiring 221a and 221b. The first through portion VH1 is provided by filling an inside of a through hole that penetrates the first surface 1S and the second surface 2S of the substrate 100 with a conductive material. Accordingly, the second-first connection wiring 221a and the second-second connection wiring 221b are electrically connected to each other.

The second wiring pattern 220 may include a second test pad TP2. The second test pad TP2 may be disposed on the second surface 2S. The second test pad TP2 may be disposed in an ineffective region UA. The second protective layer 320 is not disposed on the second test pad TP2. The second test pad TP2 can be connected to the second-second connection wiring 221b. In detail, the second test pad TP2 and the second-second connection wiring 221b can be formed integrally.

The second wiring pattern 220 can be tested before connecting the display panel and the fourth pad 222b. For example, the second test pad TP2 can be used to check whether the second wiring pattern is open or shorted.

In addition, referring to FIG. 1, FIG. 2, FIG. 3, and FIG. 6, the third wiring pattern 230 is disposed on the first surface 1S and the second surface 2S. The third wiring pattern 230 includes the third connection wiring 231, the fifth pad 232a, the sixth pad 232b, and the second via electrode V2. The third connection wiring 231, the fifth pad 232a, and the sixth pad 232b may include a same material. In addition, the third connection wiring 231, the fifth pad 232a, and the sixth pad 232b may be formed integrally.

The fifth pad 232a is disposed on the first surface 1S. The fifth pad 232a is disposed inside the chip mounting region CHA. Accordingly, the fifth pad 232a is connected to a terminal of the chip. Accordingly, the third wiring pattern 230 and the chip are connected.

The sixth pad 232b is disposed on the second surface 2S. The sixth pad 232b is connected to a terminal of the display panel. Accordingly, the third wiring pattern 230 and the display panel are connected.

The third connection wiring 231 electrically connects the fifth pad 232a and the sixth pad 232b. Accordingly, the chip and the display panel are connected. Accordingly, a signal generated from the chip is transmitted to the display panel.

A second protective layer 320 is disposed on the third wiring pattern 230. The second protective layer 320 is disposed on the third wiring pattern 230 on the second surface 2S. The second protective layer 320 is not disposed on the sixth pad 232b.

The fifth pad 232a and the third connection wiring 231 are electrically connected to each other. In detail, the fifth pad 232a and the third connection wiring 231 are connected through the second via electrode V2. The second via electrode V2 penetrates the first surface 1S and the second surface 2S. Accordingly, the second via electrode V2 is disposed on the first surface 1S and the second surface 2S. A via land of the second via electrode V2 on the first surface 1S and a via land of the second via electrode V2 on the second surface 2S are disposed at positions corresponding to each other.

The second via electrode V2 includes a second via land VL2 and a second through portion VH2. The second via land VL2 includes the same material as the third connection wiring 231. The second through portion VH2 is formed inside the second via land VL2. The second through portion VH2 is provided by filling a through hole penetrating the first surface 1S and the second surface 2S of the substrate 100 with a conductive material. Accordingly, the fifth pad 232a and the third connection wiring 231 are electrically connected to each other. The third wiring pattern 230 may include a third test pad TP3.

The third test pad TP3 may be disposed on the second surface 2S. The third test pad TP3 may be disposed on the ineffective region UA. In addition, the second protective layer 320 is not disposed on the third test pad TP3. The third test pad TP3 can be connected to the third connection wiring 231. In detail, the third test pad TP3 can be formed integrally with the third connection wiring 231.

The third wiring pattern 230 can be tested before connecting the display panel and the sixth pad 232b. For example, the third test pad TP3 can be used to check whether the third wiring pattern is open or shorted.

Although not shown in the drawing, the wiring pattern part can further include an additional wiring pattern part. For example, the wiring pattern part can further include a power supply pattern. The power supply pattern can be connected to a terminal of the circuit board and a terminal of the display panel. Accordingly, power can be transmitted to the circuit board and the display panel. That is, the additional wiring pattern part can be disposed on the first surface 1S of the substrate 100. The additional wiring pattern part can be a bypass pattern part. The additional wiring pattern part may be a bypass line directly connecting an external circuit board and a display panel, and may preferably be a power supply line.

The wiring pattern part 210, 220, and 230 may include a metal material having excellent electrical conductivity. In detail, the wiring pattern part 210, 220, and 230 may include copper (Cu). However, the embodiment is not limited thereto. The wiring pattern part 210, 220, and 230 may include at least one metal among copper (Cu), aluminum (Al), chromium (Cr), nickel (Ni), silver (Ag), molybdenum (Mo), gold (Au), titanium (Ti), and alloys thereof.

The flexible circuit board 1000 may further include a dummy pattern 240. The dummy pattern 240 may be disposed on an effective region AA and an ineffective region UA. The dummy pattern on the ineffective region UA increases a strength of the substrate 100. The dummy pattern 240 on the effective region AA improves the uniformity of the wiring pattern part. In detail, the width, thickness, and spacing of the wiring pattern part can be made uniform by the dummy pattern 240.

The dummy pattern 240 is not a pattern through which a signal moves. The dummy pattern 240 is not connected to a terminal of the circuit board and a terminal of the display panel.

The protective layer includes a first protective layer 310 and a second protective layer 320. The first protective layer is disposed on the first surface 1S. The second protective layer 320 is disposed on the second surface 2S. At least one of the first protective layer 310 and the second protective layer 320 may include a solder paste. For example, the solder paste may include a thermosetting resin, a thermoplastic resin, a filler, a curing agent, or a curing accelerator.

The first protective layer 310 is disposed on the wiring pattern part on the first surface 1S. In detail, the first protective layer 310 is disposed on the first wiring pattern 210 and the second wiring pattern 220 on the first surface 1S. The second protective layer 320 is disposed on the second wiring pattern 220 and the third wiring pattern 230 on the second surface 2S.

As described above, the wiring pattern part may include the first wiring pattern 210, the second wiring pattern 220, and the third wiring pattern 230 disposed on the first surface 1S and the second surface 2S of the substrate 100. Hereinafter, for convenience of explanation, a part of the first wiring pattern 210, the second wiring pattern 220, and the third wiring pattern 230 disposed on the first surface 1S of the substrate 100 is referred to as an upper wiring pattern 200U, and a remaining part of the first wiring pattern 210, the second wiring pattern 220, and the third wiring pattern 230 disposed on the second surface 2S of the substrate 100 is referred to as a lower wiring pattern 200L.

FIG. 7 is a cross-sectional view of a flexible circuit board according to a first embodiment taken along line A-A' of FIG. 1.

The flexible circuit board 1000 includes a first region R1 and a second region R2. The first region R1 may be defined as a bending region of the flexible circuit board 1000, and the second region R2 may be defined as a region excluding the first region R1. For example, the flexible circuit board 1000 can be bent based on the bending region BA. In addition, the first region R1 can mean the bending region BA of the flexible circuit board 1000, and the second region R2 can be defined as a remaining region excluding the bending region BA.

The flexible circuit board 1000 includes a substrate 100. An upper wiring pattern 200U is disposed on a first surface 1S of the substrate 100. In addition, a lower wiring pattern 200L is disposed on a second surface 2S of the substrate 100.

The upper wiring pattern 200U can be provided in a plurality of layers. For example, the upper wiring pattern 200U can include an upper wiring layer 200a and an upper plating layer 200b disposed on the upper wiring layer 200a.

The upper wiring layer 200a may be disposed with a thickness of 1 µm to 20 µm. For example, the upper wiring layer 200a may be disposed with a thickness of 5 µm to 20 µm. For example, the upper wiring layer 200a may be disposed with a thickness of 5 µm to 15 µm.

If the thickness of the upper wiring layer 200a is less than 1 µm, a resistance of the upper wiring layer 200a may increase. If the thickness of the upper wiring layer 200a is more than 20 µm, it may be difficult to implement a fine pattern.

An upper plating layer 200b may be disposed on the upper wiring layer 200a. The upper plating layer 200b may include a first upper plating layer 200b1 and a second upper plating layer 200b2.

The first upper plating layer 200b1 may be partially disposed on the upper wiring layer 200a. The first upper plating layer 200b1 may be disposed on the second region R2 excluding the first region R1 on the upper wiring layer 200a. The first upper plating layer 200b1 may be disposed on a region other than a region where the first protective pattern 311 of the upper protective layer 310 on the upper wiring layer 200a is disposed. For example, the first upper plating layer 200b1 may be disposed on a region where the second protective pattern 312 on the upper wiring layer 200a is disposed.

That is, the first upper plating layer 200b1 may not be disposed on the first region R1 on the upper wiring layer 200a. Accordingly, the first upper plating layer 200b1 may include an open portion 200b1O provided in the first region R1. For example, a width of the open portion 200b1O may correspond to a width of the first region R1. In detail, a side surface of the first upper plating layer 200b1 may be disposed in a boundary region between the first region R1 and the second region R1.

The first upper plating layer 200b1 may be separated from each other by an open portion 200b1O. For example, a first upper plating layer 200b1 provided outside one end of the first region R1 and a first upper plating layer 200b1 provided outside another end of the first region R1 may not be connected to each other.

The second upper plating layer 200b2 may be disposed on the first upper plating layer 200b1. The second upper plating layer 200b2 may be partially disposed on the first upper plating layer 200b1.

The second upper plating layer 200b2 may be disposed in a region other than a region where the second protective pattern 312 of the upper protective layer 310 is disposed. For example, the upper protective layer 310 may include a plurality of open regions. The upper protective layer 310 may include a first open region OR1 and a second open region OR2. The first open region OR1 of the upper protective layer 310 may correspond to a chip mounting region CHA1. The second open region OR2 of the upper protective layer 310 may be a first connection region connected to an external circuit board. That is, the substrate 100 may include a first side end and a second side end opposite to the first side end. In addition, the first open region OR1 may be located between the first side end and the second side end. In addition, the second open region OR2 may be spaced apart from the first open region OR1 and may be located closer to the first side end than the first open region OR1.

In addition, the second upper plating layer 200b2 may be provided in a region other than the second open region OR2 on the first upper plating layer 200b1.

That is, the upper plating layer 200b may not be disposed in the first region R1 of the flexible circuit board 1000 of the embodiment. Specifically, the first upper plating layer 200b1 and the second upper plating layer 200b2 may not be disposed in the first region R1 of the flexible circuit board 1000. Through this, the embodiment can prevent cracks occurring during bending of the flexible circuit board 1000 in the first region R1, and thereby improving physical reliability and/or electrical reliability of the flexible circuit board 1000. In addition, the embodiment can prevent the upper wiring pattern 200U from being damaged by a tensile force of the upper wiring pattern 200U that occurs when the flexible circuit board 1000 is bent in the first region R1, thereby improving the durability of the upper wiring pattern 200U.

In this way, the upper plating layer 200b can be provided in two layers. That is, the upper plating layer 200b can include a first upper plating layer 200b1 and a second upper plating layer 200b2. The first upper plating layer 200b1 and the second upper plating layer 200b2 can be formed in two layers on the upper wiring layer 200a in order to prevent a formation of whiskers. That is, the first upper plating layer 200b1 and the second upper plating layer 200b2 can be disposed on the first open region OR1 and the second open region OR2 of the upper protective layer 310. Accordingly, a short circuit between patterns of the upper wiring layer 200a can be prevented.

The upper plating layer 200b can include tin (Sn). For example, the first upper plating layer 200b1 and the second upper plating layer 200b2 can include tin (Sn). For example, the upper wiring layer 200a can include copper (Cu), and the first upper plating layer 200b1 and the second upper plating layer 200b2 can include tin (Sn). If the upper plating layer 200b contains tin, the corrosion resistance of tin (Sn) is excellent, and thus, oxidation of the upper wiring layer 200a in the region where the upper protective layer 310 is not arranged can be prevented.

The upper protective layer 310 may have a two-layer structure including a first protective pattern 311 and a second protective pattern 312.

The first protective pattern 311 of the upper protective layer 310 may be provided in the first region R1 of the flexible circuit board. That is, the first protective pattern 311 of the upper protective layer 310 may be in direct contact with the upper wiring layer 200a of the upper wiring pattern 200U. For example, a lower surface of the first protective pattern 311 of the upper protective layer 310 may be in direct contact with an upper surface of the upper wiring layer 200a and may not be in contact with the upper plating layer 200b.

The second protective pattern 312 of the upper protective layer 310 may be disposed on the first protective pattern 311 and the first upper plating layer 200b1. That is, the second protective pattern 312 of the upper protective layer 310 may be disposed in a region excluding the first open region OR1 and the second open region OR2.

Accordingly, the first surface 1S of the substrate 100 may include a first arrangement region where the upper wiring layer 200a, the first protective pattern 311, and the second protective pattern 312 are disposed, a second arrangement region where the upper wiring layer 200a, the first upper plating layer 200b1, and the second protective pattern 312 are disposed, and a region where the upper wiring layer 200a, the first upper plating layer 200b1, and the second upper plating layer 200b1 are disposed.

A structure as described above may include a first process of applying a first protective pattern 311 of an upper protective layer 310 on an upper wiring layer 200a, a second process of plating a first upper plating layer 200b1 with tin (Sn) on the upper wiring layer 200a, a third process of plating a second protective pattern 312 on the first protective pattern 311 and the first upper plating layer 200b1, and a fourth process of plating a second upper plating layer 200b2 with tin (Sn).

At this time, the upper wiring layer 200a and the upper plating layer 200b may experience a diffusion action of copper (Cu) of the upper wiring layer 200a or tin (Sn) of the upper plating layer 200b in a heat treatment process. Accordingly, the diffusion concentration of copper (Cu) decreases from the first upper plating layer 200b1 to a surface of the second upper plating layer 200b2, and thus, a content of copper (Cu) may decrease. Meanwhile, a content of tin (Sn) may increase from the first upper plating layer 200b1 to a surface of the second upper plating layer 200b2.

The first upper plating layer200b1 and the second upper plating layer200b2 may be an alloy of tin and copper due to a chemical reaction at a laminated interface of the upper wiring layer 200a and the upper plating layer 200b. In addition, the first upper plating layer 200b1 and the second upper plating layer 200b2 may have different contents of tin and copper. That is, the first upper plating layer 200b1 in direct contact with the upper wiring layer 200a may have a higher copper content than the second upper plating layer 200b2. Alternatively, the first upper plating layer 200b1 may be an alloy of tin and copper, and the second upper plating layer 200b2 may include tin. A plating layer according to the embodiment may prevent electrochemical migration (Electrochemical Migration Resistance) due to a diffusion phenomenon of Cu/Sn, thereby preventing short-circuiting defects caused by metal growth.

However, the embodiment is not limited thereto, and the plating layer may include any one of Ni/Au alloy, gold (Au), electroless nickel immersion gold (ENIG), Ni/Pd alloy, and organic solderability preservative (OSP).

The first upper plating layer 200b1 may have a thickness different from that of the second upper plating layer 200b2. The thickness of the first upper plating layer 200b1 may be smaller than the thickness of the second upper plating layer 200b2. For example, the first upper plating layer 200b1 may have a thickness of 0.1 µm or less. For example, the second upper plating layer 200b2 may have a thickness of 1 µm or less. That is, a total thickness of the upper plating layer 200b may be 1.1 µm or less.

The upper protective layer 310 may include a first protective pattern 311 and a second protective pattern 312. The first protective pattern 311 may be disposed on a first region R1 which is a bending region of the upper wiring layer 200a, and the second protective pattern 312 may be disposed on the first protective pattern 311.

The first protective pattern 311 may be in contact with the upper wiring layer 200a and the first upper plating layer 200b1. The first protective pattern 311 may be in contact with an upper surface of the upper wiring layer 200a and a side surface of the first upper plating layer 200b1 on the first region R1.

That is, the first protective pattern 311 is in direct contact with the upper wiring layer 200a, and thus, stress that may occur during bending of the first region R1 can be dispersed, and thus, physical reliability and/or electrical reliability of the flexible circuit board can be further improved. In addition, a lower surface of the second protective pattern 312 is in contact with the first upper plating layer 200b1 and does not contact the second upper plating layer 200b1. Accordingly, a thickness of the flexible circuit board can be prevented from increasing by a thickness of the second upper plating layer 200b2.

Meanwhile, a lower wiring pattern 200L and a lower protective layer 320 can be disposed on the second surface 2S of the substrate 100.

A lower wiring pattern 200L is disposed on the second surface 2S of the substrate 100. In addition, a lower wiring pattern 200L is disposed on the second surface 2S of the substrate 100.

The lower wiring pattern 200L may be provided with a plurality of layers. For example, the lower wiring pattern 200L may include a lower wiring layer 200c and a lower plating layer 200d disposed on the lower wiring layer 200c.

The lower wiring layer 200c may be disposed with a thickness of 1 µm to 20 µm. For example, the lower wiring layer 200c may be disposed with a thickness of 5 µm to 20 µm. For example, the lower wiring layer 200c may be disposed with a thickness of 5 µm to 15 µm.

If the thickness of the lower wiring layer 200c is less than 1 µm, the resistance of the lower wiring layer 200c may increase. If the thickness of the lower wiring layer 200c exceeds 20µm, it may be difficult to implement a fine pattern.

A lower plating layer 200d may be disposed on the lower wiring layer 200c. The lower plating layer 200d may include a first lower plating layer 200d1 and a second lower plating layer 200d2.

The first lower plating layer 200d1 may be partially disposed under the lower wiring layer 200c. The first lower plating layer 200d1 may not overlap the lower protective layer 320 along the thickness direction. That is, the lower protective layer 320 may include a third open region OR3. The third open region OR3 may be a second connection region for connecting the lower wiring pattern 200L and the display panel. The third open region OR3 may be positioned closer to the second side end of the substrate 100 than the first open region OR1.

The second lower plating layer 200d2 may be positioned under the first lower plating layer 200d1. The second lower plating layer 200d2 may be positioned in the third open region OR3 of the lower protective layer 320.

The first lower plating layer 200d1 and the second lower plating layer 200d2 may not be disposed between the lower wiring layer 200c and the lower protective layer 320. For example, an upper surface of the lower protective layer 320 may not be in contact with the first lower plating layer 200d1 and the second lower plating layer 200d2. The first lower plating layer 200d1 and the second lower plating layer 200d2 may be selectively disposed only in the third open region OR3 of the lower protective layer 320.

That is, the embodiment prevents the lower plating layer 200d from being disposed between the lower wiring layer 200c and the lower protective layer 320. Accordingly, the embodiment can prevent the bending characteristics of the flexible circuit board from being deteriorated by the lower plating layer 200d. Furthermore, the embodiment can prevent the occurrence of cracks in the lower wiring pattern 200L by the lower plating layer 200d when the flexible circuit board is bent. Therefore, the embodiment can further improve the durability of the lower wiring pattern.

In addition, a via electrode is provided in the substrate 100 to connect the upper wiring pattern 200U and the lower wiring pattern 200L. The via electrode includes a first via electrode V1 overlapping the first open region OR1 along a thickness direction. In addition, the via electrode includes a second via electrode V2 adjacent to one side end of the substrate 100 from the first open region OR1. In addition, the embodiment provides the first region R1 between the first via electrode V1 and the second via electrode V2. Preferably, the first region R1 can extend between the first via electrode V1 and the second via electrode V2 in a direction perpendicular to a separation direction of the first via electrode V1 and the second via electrode V2. Through this, the embodiment can improve the rigidity of the flexible circuit board by the first via electrode V1 and the second via electrode V2 when the flexible circuit board is bent in the first region R1, thereby further improving the physical reliability and/or electrical reliability of the flexible circuit board.

In addition, a lower wiring pattern 200L may not be disposed in a region of the second surface 2S of the substrate 100. Preferably, the lower wiring pattern 200L may not overlap with a region between the first open region OR1 and the second open region OR2 of the upper protective layer 310 in the thickness direction. Preferably, the lower wiring pattern 200L may not be disposed in a region that overlaps in the thickness direction with a region between the first open region OR1 and the second open region OR2 of the upper protective layer 310 among the second surface 2S of the substrate 100, and may be disposed in a region that does not overlap in the thickness direction with the region between the first open region OR1 and the second open region OR2 of the upper protective layer 310. Through this, the embodiment can control the tensile force of the lower wiring pattern 200L that occurs when the flexible circuit board is bent by controlling an arrangement region of the lower wiring pattern 200L, and can further improve the durability of the lower wiring pattern 200L accordingly. However, a lower dummy pattern may be provided under the second surface 2S of the substrate 100 that overlaps the region between the first open region OR1 and the second open region OR2 of the upper protective layer 310 in the thickness direction.

In addition, a region in which a metal content changes may be included between the upper wiring layer 200a and the upper protective layer 310. Specifically, the upper wiring layer 200a may include a first overlapping region that overlaps the upper protective layer 310 in the thickness direction. In addition, the first overlapping region of the upper wiring layer 200a may include a region in which the metal content changes. For example, the first overlapping region between the upper wiring layer 200a and the upper protective layer 310 may include a region where a copper content changes or a region where a tin content changes by the upper plating layer 200b.

In contrast, a region where a metal content changes may not be included between the lower wiring layer 200c and the lower protective layer 320. That is, the lower plating layer 200d is not disposed between the lower wiring layer 200c and the lower protective layer 320, and thus, a region where a copper content changes or a region where a tin content changes may not be included. Specifically, the lower wiring layer 200c may include a second overlapping region that overlaps the lower protective layer 320 in the thickness direction. In addition, a metal content in the second overlapping region of the lower wiring layer 200c may not change and may be constant. That is, even if the second overlapping region between the lower wiring layer 200c and the lower protective layer 320 includes a region in which the metal content changes, an amount of change in the metal content in the second overlapping region between the lower wiring layer 200c and the lower protective layer 320 may be smaller than an amount of change in a metal content in the first overlapping region between the upper wiring layer 200a and the upper protective layer 310.

That is, the upper protective layer 311 is in direct contact with the first upper plating layer 200b1 in the first overlapping region, and the lower protective layer 312 is in direct contact with the lower wiring layer 200c in the second overlapping region. Accordingly, the metal content or the amount of change in the metal content in the first overlapping region may be different from the metal content or the amount of change in the metal content in the second overlapping region.

The flexible circuit board of the embodiment described above includes a substrate, an upper wiring pattern, a lower wiring pattern, an upper protective layer, and a lower protective layer. The substrate includes a first region corresponding to a bending region, and a second region excluding the first region. In addition, the upper wiring pattern includes an upper wiring layer, a first upper plating layer, and a second upper plating layer. At this time, the first and second upper plating layers may not be disposed in the first region of the flexible circuit board of the embodiment. Accordingly, the embodiment can prevent cracks occurring during bending of the flexible circuit board in the first region, thereby further improving physical reliability and/or electrical reliability of the flexible circuit board. In addition, the embodiment can prevent damage to the upper wiring pattern due to tensile force of the upper wiring pattern occurring during bending of the flexible circuit board in the first region, thereby improving durability of the upper wiring pattern.

In addition, a second protective pattern of the upper protective layer may be provided on the first upper plating layer to surround the first protective pattern of the upper protective layer provided in the open portion of the first upper plating layer.

That is, the first protective pattern of the upper protective layer may be in contact with the upper wiring layer and the first upper plating layer. The first protective pattern may be in contact with the upper surface of the upper wiring layer on the first region and a side surface of the first upper plating layer. That is, the first protective pattern is in direct contact with the upper wiring layer, and thus, stress that may occur during bending in the first region may be dispersed, and thus, physical reliability and/or electrical reliability of the flexible circuit board may be further improved. In addition, a lower surface of the second protective pattern is in contact with the first upper plating layer and does not contact the second upper plating layer. Accordingly, a thickness of the flexible circuit board may be prevented from increasing by a thickness of the second upper plating layer.

In addition, the lower wiring pattern includes a lower wiring layer, a first lower plating layer, and a second lower plating layer. At this time, the lower protective layer includes a third open region. In addition, the first lower plating layer and the second lower plating layer of the lower wiring pattern are disposed only in the third open region of the lower protective layer. That is, the first lower plating layer and the second lower plating layer may not be disposed between the lower wiring layer and the lower protective layer.

Specifically, the first lower plating layer and the second lower plating layer may not be disposed between the lower wiring layer and the lower protective layer. For example, an upper surface of the lower protective layer may not contact the first lower plating layer and the second lower plating layer. The first lower plating layer and the second lower plating layer may be selectively disposed only in the third open region of the lower protective layer.

That is, the embodiment prevents the lower plating layer from being disposed between the lower wiring layer and the lower protective layer. Accordingly, the embodiment can prevent the bending characteristics of the flexible circuit board from being deteriorated by the lower plating layer. Furthermore, the embodiment can prevent the occurrence of cracks in the lower wiring pattern by the lower plating layer when the flexible circuit board is bent. Therefore, the embodiment can further improve the durability of the lower wiring pattern.

In addition, a via electrode is disposed in the substrate to connect the upper wiring pattern and the lower wiring pattern. The via electrode includes a first via electrode overlapping the first open region along the thickness direction. In addition, the via electrode includes a second via electrode adjacent to one side end of the substrate from the first open region. In addition, the embodiment provides a first region between the first via electrode and the second via electrode. Preferably, the first region can extend in a direction perpendicular to a separation direction of the first via electrode and the second via electrode between the first via electrode and the second via electrode. Through this, the embodiment can improve the rigidity of the flexible circuit board by the first via electrode and the second via electrode when the flexible circuit board is bent in the first region, thereby further improving the physical reliability and/or electrical reliability of the flexible circuit board.

In addition, the lower wiring pattern may not be disposed in a region of the second surface of the substrate. Preferably, the lower wiring pattern may not overlap with a region between the first open region and the second open region of the upper protective layer in the thickness direction. Preferably, the lower wiring pattern may not be disposed in a region of the second surface of the substrate that overlaps in the thickness direction with the region between the first open region and the second open region of the upper protective layer, and may be provided in a region of the second surface of the substrate that does not overlap in the thickness direction with the region between the first open region and the second open region of the upper protective layer. Through this, the embodiment can control an arrangement region of the lower wiring pattern to control the tensile force of the lower wiring pattern that occurs when the flexible circuit board is bent, thereby further improving the durability of the lower wiring pattern.

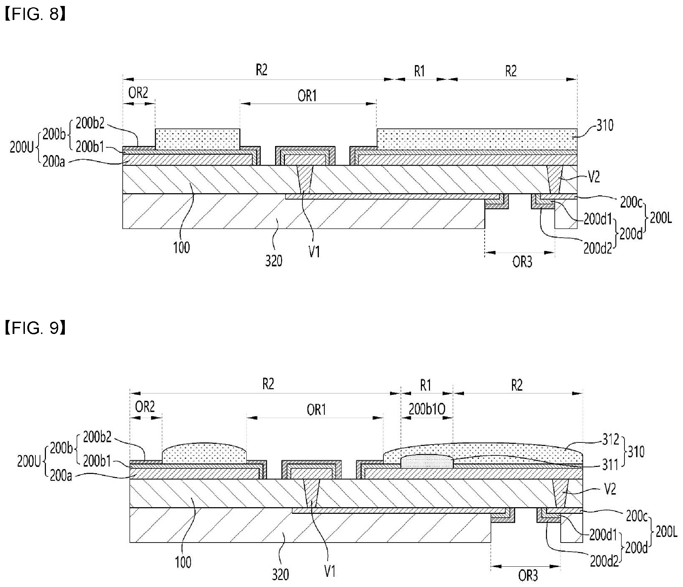

FIG. 8 is a cross-sectional view of a flexible circuit board according to a second embodiment taken along line A-A' of FIG. 1.

Referring to FIG. 8, the flexible circuit board of the embodiment may have a different structure of the upper protective layer 310 compared to the flexible circuit board of FIG. 7.

For example, the first upper plating layer 200b1 may not have an open portion. Accordingly, the upper protective layer 310 of FIG. 8 may have a structure including only the second protective pattern 312 among the first protective pattern 311 and the second protective pattern 312 of the upper protective layer of FIG. 7.

That is, in the embodiment, the lower wiring pattern 200L between the lower wiring pattern 200L and the lower protective layer 320 may include only the lower wiring layer 200c. Accordingly, the embodiment may have a single-layer structure in which the upper protective layer 310 includes only the second protective pattern 312, rather than a two-layer structure in which the first protective pattern 311 and the second protective pattern 312 are included. In addition, even if the upper protective layer has a single-layer structure, the embodiment may prevent the upper wiring pattern and/or the lower wiring pattern from being damaged by the tensile force of the upper wiring pattern and/or the lower wiring pattern that occurs when the flexible circuit board is bent, thereby improving the durability of the upper wiring pattern and/or the lower wiring pattern.

FIG. 9 is a cross-sectional view of a flexible circuit board according to the third embodiment taken along line A-A' of FIG. 1.

Referring to FIG. 9, the flexible circuit board of the embodiment may have a different structure of the upper protective layer 310 compared to the flexible circuit board of FIG. 7. For example, upper surfaces of the first protective pattern 311 and the second protective pattern 312 of the upper protective layer 310 of FIG. 9 may have a rounded shape. Preferably, the upper surfaces of the first protective pattern 311 and the second protective pattern 312 may have curved surfaces. For example, the upper surfaces of each of the first protective pattern 311 and the second protective pattern 312 may vary in height along a horizontal direction.

Through this, the embodiment may disperse a stress applied to the first protective pattern 311 and the second protective pattern 312 by making the upper surfaces of the first protective pattern 311 and the second protective pattern 312 have curved surfaces, thereby further improving the physical reliability and/or electrical reliability of the flexible circuit board.

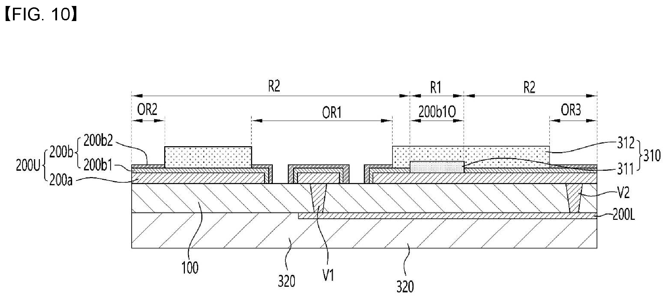

FIG. 10 is a cross-sectional view of a flexible circuit board according to a fourth embodiment taken along line A-A' of FIG. 1.

Referring to FIG. 10, the flexible circuit board according to the fourth embodiment can be connected to each of the external circuit board and the display panel on the first surface S1 of the substrate 100.

Accordingly, the upper protective layer 310 can include a first open region OR1, a second open region OR2, and a third open region OR3.

In addition, the lower protective layer 320 may not have an open region.

Accordingly, the lower wiring pattern 200L may have only a lower wiring layer as a whole. For example, the lower wiring pattern 200L may not have a plating layer.

Below, a flexible circuit board according to another embodiment is described.

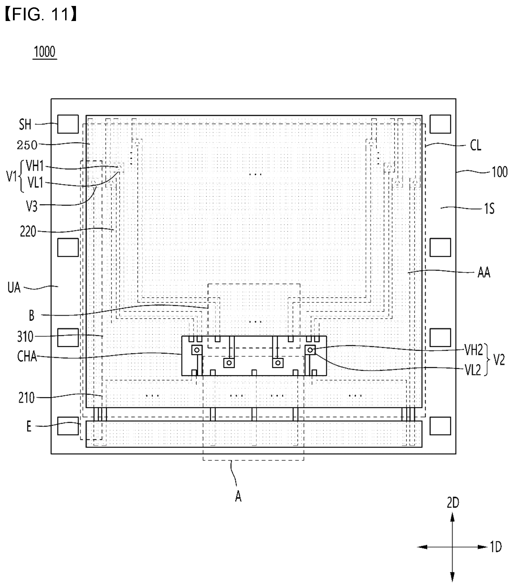

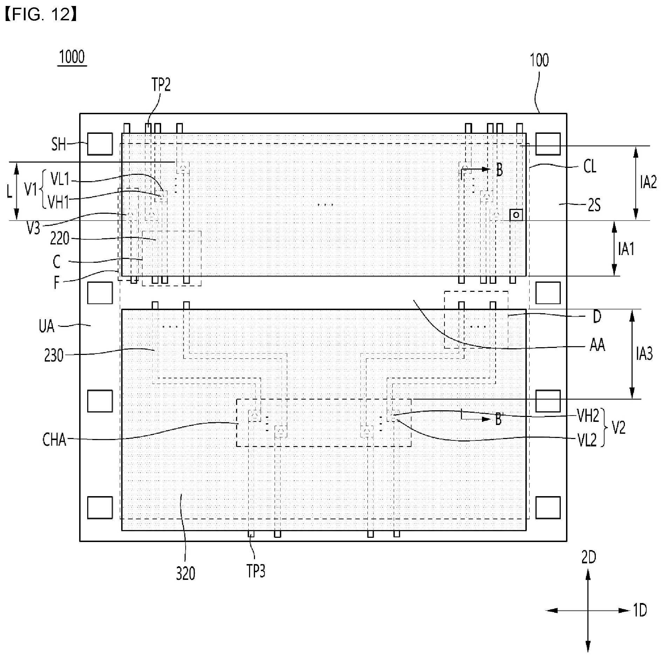

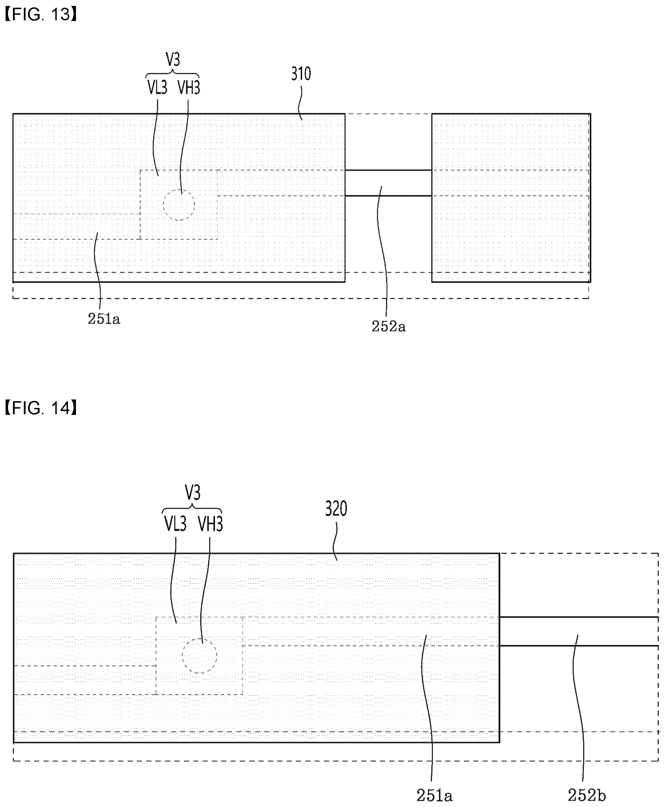

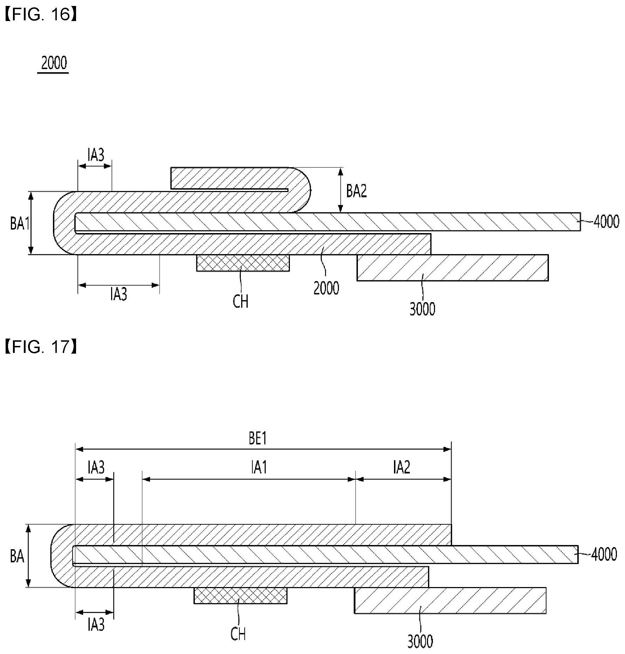

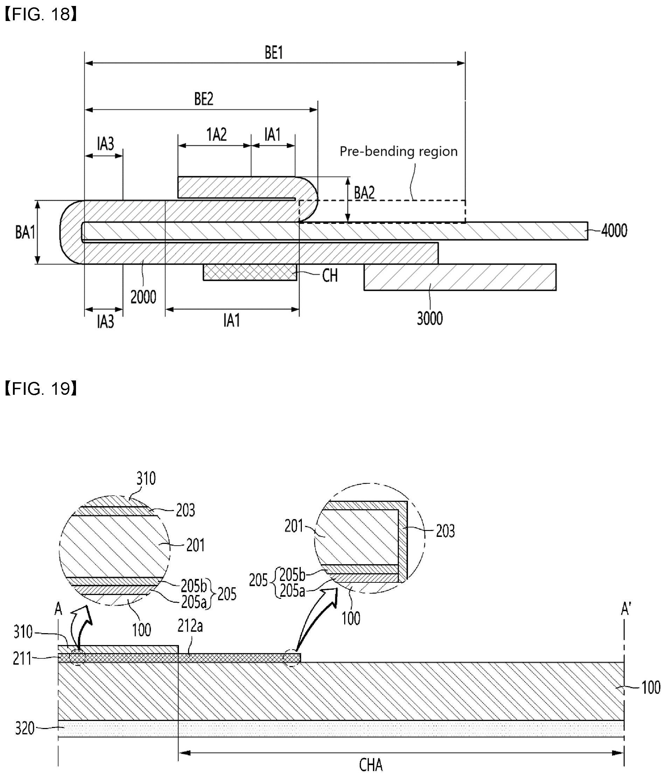

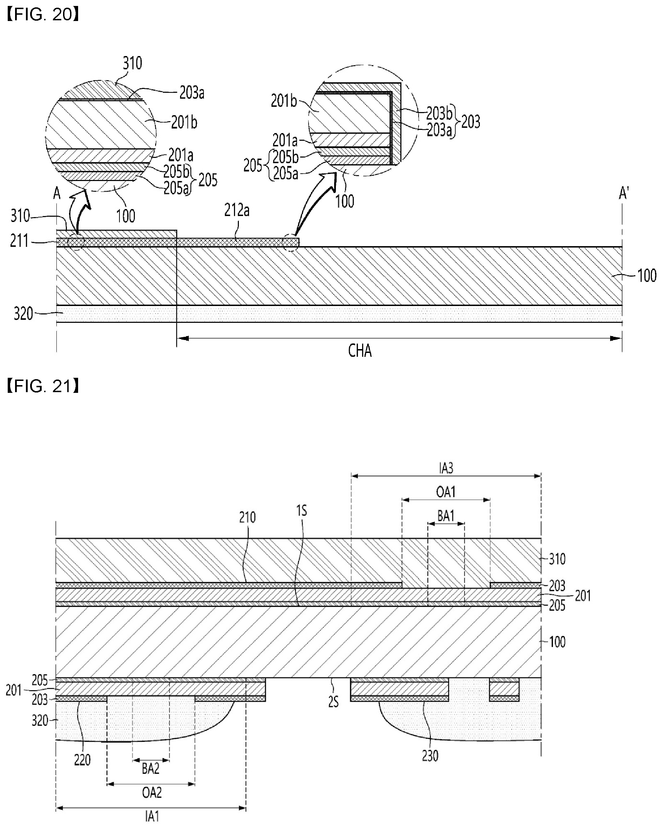

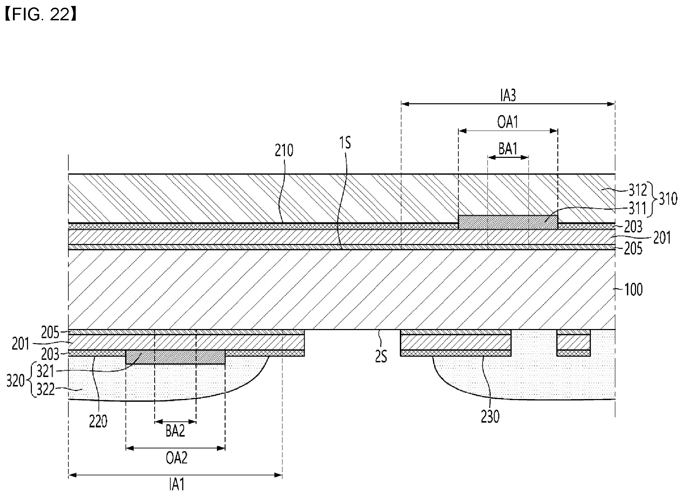

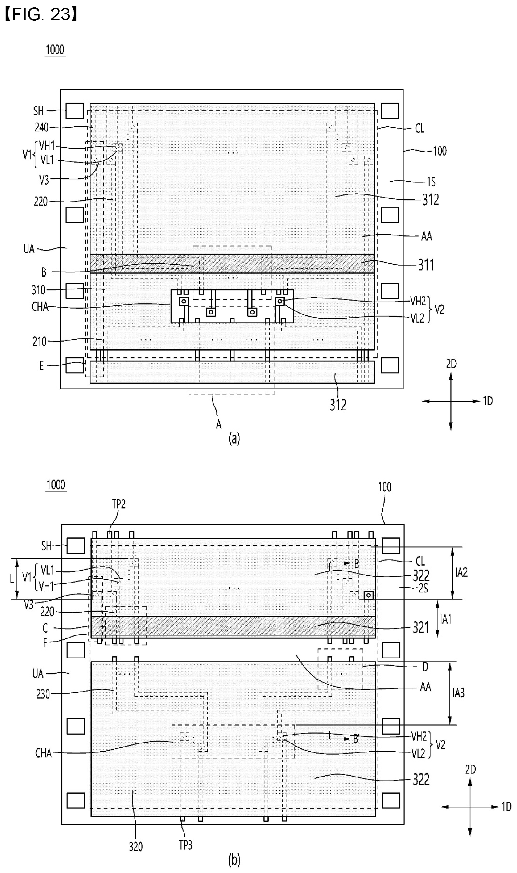

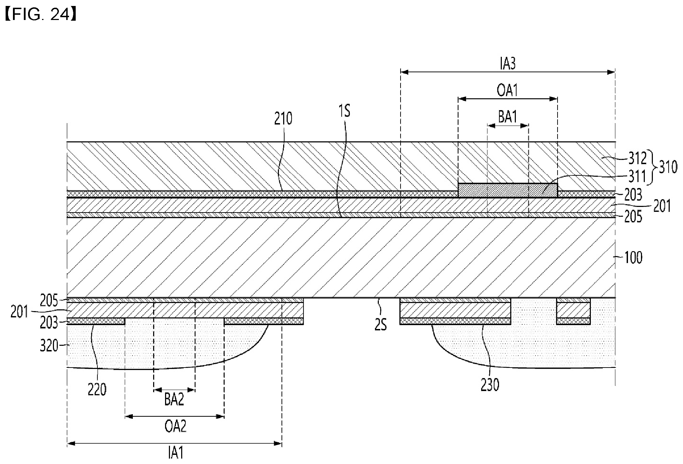

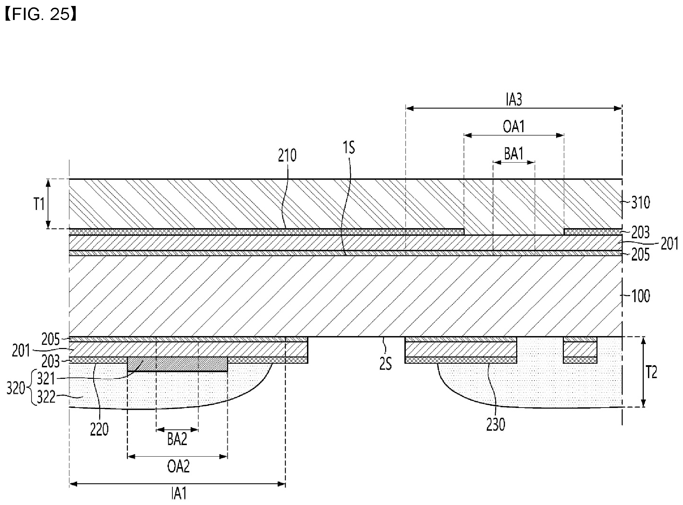

FIG. 11 is a top view of a flexible circuit board according to a fifth embodiment, FIG. 12 is a bottom view of a flexible circuit board according to a fifth embodiment, FIG. 13 is a view showing an enlarged view of region E of FIG. 11, FIG. 14 is a view showing an enlarged view of region F of FIG. 11, FIGS. 15 and 16 are views for explaining a shape of a COF module being bent, FIGS. 17 and 18 are views for explaining a shape of a COF module being bent according to an embodiment, FIGS. 19 and 20 are cross-sectional views taken along line A-A' of FIG. 3 according to a fifth embodiment, FIGS. 21 and 22 are cross-sectional views taken along line B-B' of FIG. 12, FIG. 23 is a view for explaining positions of protective layers according to a fifth embodiment, and FIG. 24 and FIG. 25 are cross-sectional views taken along region B-B' of FIG. 12.

In the following description, same reference numerals are given to configurations that are substantially the same as configurations of the flexible circuit board described with reference to FIGS. 1 to 10, and their detailed descriptions are omitted.

Referring to FIGS. 11 to 14, the flexible circuit board may further include a fourth wiring pattern 250.

The fourth wiring pattern 250 is disposed on the first surface 1S and the second surface 2S. The fourth wiring pattern 250 includes fourth connection wirings 251a and 251b, a seventh pad 252a, an eighth pad 252b, and a third via V3. The fourth connection wirings 251a and 251b, the seventh pad 252a, and the eighth pad 252b may include a same material. In addition, the fourth connection wiring 251a and 251b, the seventh pad 252a, and the eighth pad 252b may be formed integrally.

The seventh pad 252a is disposed on the first surface 1S. The seventh pad 252a is disposed adjacent to the first pad 212a. The seventh pad 252a is connected to a terminal of an external circuit board. As a result, the fourth wiring pattern 220 and the circuit board are connected.

The eighth pad 252b is disposed on the second surface 2S. The eighth pad 252b is connected to a terminal of an external display panel. As a result, the fourth wiring pattern 250 and the display panel are connected.

The fourth connection wiring includes a fourth-first connection wiring 251a and a fourth-second connection wiring 251b. The fourth-first connection wiring 251a is disposed on the first surface 1S. The fourth-second connection wiring 251b is disposed on the second surface 2S. The fourth-first connection wiring connects the seventh pad 252a and the eighth pad 252b. The fourth-first connection wiring 251a is connected to the seventh pad 252a. The fourth-second connection wiring 251b is connected to the eighth pad 252b.

The fourth wiring pattern 250 may be a power supply pattern. Power may be transmitted to the circuit board and the display panel by the fourth wiring pattern 250.

A first protective layer 310 and a second protective layer 320 are disposed on the fourth wiring pattern 250. In detail, the first protective layer 310 is disposed on the fourth wiring pattern 250 on the first surface 1S. The second protective layer 320 is disposed on the fourth wiring pattern 250 on the second surface 2S. The first protective layer 310 and the second protective layer 320 are not disposed on the seventh pad 252a and the eighth pad 252b.

The fourth-first connection wiring 251a and the fourth-second connection wiring 251b are connected. The fourth-first connection wiring 251a and the fourth-second connection wiring 251b are connected through a third via V3. The third via V3 is formed by penetrating the first surface 1S and the second surface 2S. Accordingly, the third via V3 is disposed on the first surface 1S and the second surface 2S. The third via V3 on the first surface 1S and the third via V3 on the second surface 2S are disposed at positions corresponding to each other.

The third via V3 includes a third via land VL3 and a third through portion VH3. The third via land VL3 and the fourth connection wiring 251a and 251b include a same material. The third through portion VH3 is formed inside the third via land VL3. A conductive material is disposed in the third through portion VH3. Accordingly, the fourth-first connection wiring 251a and the fourth-second connection wiring 251b are electrically connected.

Meanwhile, as described above, the second wiring pattern 220 includes a plurality of first vias V1. A number of first vias V1 corresponds to a number of pads of the second wiring pattern 220. Accordingly, the number of first vias V1 is proportional to the number of terminals of the display panel.

A number of terminals provided in the display panel for VR is large. Therefore, when the flexible circuit board and the display panel for VR are connected, the number of first vias V1 increases. The first vias V1 can be disposed in various ways depending on a width of the first direction 1D and a length of the second direction 2D of the flexible circuit board.

For example, a plurality of first via groups may be defined. The first via group includes a plurality of first vias V1 disposed in the second direction 2D. In addition, the first via groups are spaced apart in the first direction 1D.

The number of first vias V1 of the first via group may vary depending on a width of the flexible circuit board 1000 in the first direction 1D and a length in the second direction 2D. In addition, the number of first via groups may vary depending on a width of the flexible circuit board 1000 in the first direction 1D and a length in the second direction 2D.

For example, when a width of the flexible circuit board 1000 is large, the number of first vias V1 of the first via group may decrease. In addition, the number of first via groups may increase. For example, the width of the flexible circuit board connected to a mobile display panel may be large. Accordingly, the flexible circuit board connected to the mobile display panel may have a smaller number of first vias V1 of the first via group. In addition, the number of the first via group may be larger.

Alternatively, when the width of the flexible circuit board 1000 is small, the number of first vias V1 of the first via group may be larger. In addition, the number of the first via group may be smaller. For example, the flexible circuit board connected to the VR display panel may have a smaller width. In addition, the flexible circuit board connected to the VR display panel may have a larger number of first vias V1 of the first via group. In addition, the number of the first via group may be smaller.

At this time, referring to FIG. 12, the flexible circuit board 1000 includes a plurality of separation regions. For example, the flexible circuit board 1000 may include a first separation region IA1, a second separation region IA2, and a third separation region IA3. The first separation region IA1 is a region between the fourth pad 222b and the first via V1 closest to the fourth pad 222b. The second separation region IA2 is a region between the first via V1 closest to the fourth pad 222b and the cutting line CL. The third separation region IA3 is a region between the sixth pad 232b and the chip mounting region CHA.

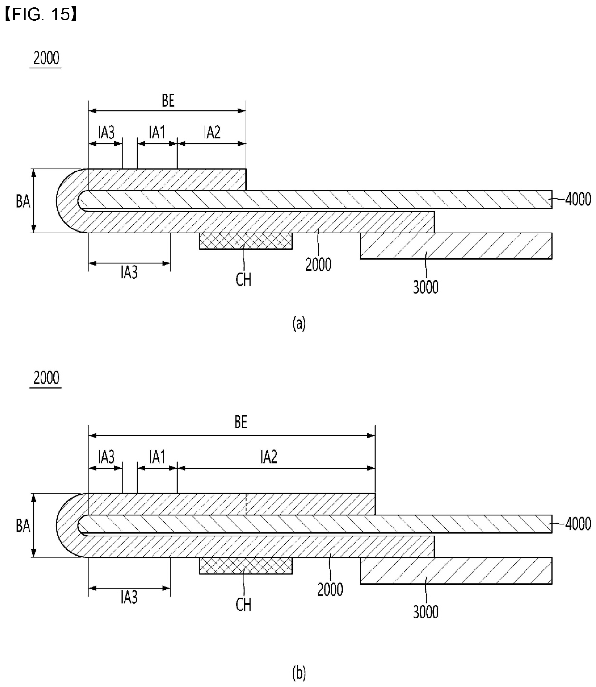

The COF module 2000 may be bent. Referring to FIG. 15, the COF module 2000 may be bent at the third separation region IA3. Therefore, the COF module 2000 includes a bending region BA. In detail, the third separation region IA3 includes a bending region BA.

Accordingly, the first separation region IA1 and the second separation region IA2 overlap with the display panel 4000. Therefore, the first separation region IA1 and the second separation region IA2 become a bezel region of the display panel 4000. Therefore, as shown in (b) of FIG. 15, when a length of the first separation region IA1 and the second separation region IA2 increases, a bezel region of the display panel 4000 increases.

For example, if the number of the first vias V1 of the first via group increases, the length of the second separation region IA2 increases. Accordingly, the bezel region of the display panel 4000 increases. For example, in a case of a COF module 2000 connected to a display panel for VR, the number of the first vias V1 of the first via group is large. Accordingly, the length of the second separation region IA2 is increased. Accordingly, the bezel region BE of the display panel 4000 is increased.

Alternatively, if the size of the first via V1 of the first via group is increased, the bezel region of the display panel 4000 may be increased. For example, in a case of a COF module 2000 connected to a mobile display panel, the number of the first vias V1 of the first via group is small. However, the size of the first via V1 may be increased. Accordingly, since the length of the second separation region IA2 is increased, the bezel region BE of the display panel 4000 may be increased.

Accordingly, the COF module 2000 according to the embodiment is bent in at least two regions. Referring to FIG. 16, the COF module 2000 may include a first bending region BA1 and a second bending region BA2.

In detail, referring to FIG. 17, the flexible circuit board 1000 includes a bending region BA. In detail, the third separation region IA3 includes a bending region BA. When the flexible circuit board 1000 is bent only in the third separation region IA3, the first bezel region BE1 of the display panel 4000 increases. In detail, the first bezel region BE1 includes a part of the third separation region IA3, the first separation region IA1, and the second separation region IA2.

However, referring to FIG. 18, the flexible circuit board 1000 includes a first bending region BA1 and a second bending region BA2. The third separation region IA3 includes the first bending region BA1. In addition, the first separation region IA1 includes the second bending region BA2. When the first separation region IA1 is bent, the second bezel region BE2 of the display panel 4000 is reduced.

In FIG. 18, the first separation region IA1 is shown to be bent only once. However, the embodiment is not limited thereto. For example, the first separation region IA1 may be bent at least twice. That is, the first separation region IA1 may include at least two or more bending regions.

The flexible circuit board 1000 according to the embodiment is bent at the first separation region IA1. Accordingly, the bezel region of the display panel is reduced.

In addition, the flexible circuit board is not bent at the second separation region IA2. Accordingly, the flexible circuit board 1000 is not bent at the region where the first via V1 is formed.

Therefore, when the flexible circuit board 1000 is bent, stress can be prevented from being transmitted to the first via. Accordingly, it is possible to prevent an alignment of the first via from being misaligned due to stress. In addition, it is possible to prevent a shape or size of the first via from being changed.

Since the flexible circuit board is bent in the first separation region IA1 and the third separation region IA3, stress occurs in the first bending region BA1 and the second bending region BA2. Therefore, the wiring pattern on the first bending region BA1 and the second bending region BA2 may be peeled off. Alternatively, the protective layer on the first bending region BA1 and the second bending region BA2 may be peeled off.

Hereinafter, a flexible circuit board 1000 and a COF module capable of solving the above problems will be described.

First, a layer structure of the wiring pattern will be described with reference to FIGS. 19 and 20. Hereinafter, the first wiring pattern will be described as an example for convenience of explanation. The following description applies equally to the second to fourth wiring patterns.

Referring to FIG. 19, the first wiring pattern is formed in multiple layers. In detail, a first connection wiring 211, a first pad 212a and a second pad 212b include a buffer layer 205, a metal layer 201, and a bonding layer 203.

The buffer layer 205 may include multiple layers. In detail, the buffer layer 205 includes a first buffer layer 205a and a second buffer layer 205b. The first buffer layer 205a is disposed on the substrate 100. The second buffer layer 205b is disposed on the first buffer layer 205a.

The first buffer layer 205a includes a material having good adhesion to the substrate 100. For example, the first buffer layer 205a may include nickel (Ni). In addition, the second buffer layer 205b includes a material having good adhesion to the first wiring pattern. For example, the second buffer layer 205b may include chromium (Cr).

The buffer layer 205 may have a thin film thickness in nanometer units. For example, the buffer layer 205 may have a thickness of 20nm or less. An adhesion between the substrate 100 and the first wiring pattern is improved by the buffer layer 205.

The metal layer 201 is disposed on the buffer layer 205. In detail, the metal layer 201 is disposed on the second buffer layer 205b. The metal layer 201 includes a metal material. For example, the metal layer 201 may include copper (Cu).

The metal layer 201 may be formed by electroplating using the buffer layer as a seed layer. That is, the metal layer 201 may be a plating layer. The thickness of the metal layer 201 may be 10µm to 30µm.

The bonding layer 203 is disposed on the metal layer 201. The bonding layer 203 is disposed on a side surface and an upper surface of the metal layer 201. For example, the bonding layer 203 may be disposed while surrounding the metal layer 201. The bonding layer 203 includes a metal. For example, the bonding layer 203 may include tin (Sn). A thickness of the bonding layer 203 may be 0.3 µm to 0.7 µm. Ae content of tin may increase as it extends from a lower surface to an upper surface of the bonding layer 203.

Here, the bonding layer 203 may mean the plating layer described in the previous embodiment. For example, the bonding layer disposed on the substrate may mean the upper plating layer described in the previous embodiment, and the bonding layer disposed under the substrate may mean the lower plating layer described in the previous embodiment.

That is, the bonding layer 203 is in contact with the metal layer 201. Accordingly, a tin content increases from the lower surface to the upper surface of the bonding layer 203. Also, a copper content decreases from the lower surface to the upper surface of the bonding layer 203.

Accordingly, pure tin may remain in a thickness range of 0.1 µm to 0.3 µm from the upper surface of the bonding layer 203.

The pad may be easily bonded to the terminals of the chip, the circuit board, and the display panel by the bonding layer 203. For example, when heat and pressure are applied to the pad, the upper surface of the bonding layer melts. Pure tin remains on the upper surface of the bonding layer. Therefore, the pad may be easily bonded to the terminals of the chip, the circuit board, and the display panel.

Referring to FIG. 20, the metal layer 201 may include a first metal layer 201a and a second metal layer 201b. The first metal layer 201a is disposed on the buffer layer 205. The second metal layer 201b is disposed on the first metal layer 201a.

A thickness of the first metal layer 201a may be smaller than a thickness of the second metal layer 201b. For example, the thickness of the first metal layer 201a may be 0.7 µm to 2 µm, and the thickness of the second metal layer 201b may be 10 µm to 25 µm.

The first metal layer 201a and the second metal layer 201b may include a same metal material. For example, the first metal layer 201a and the second metal layer 201b may include copper (Cu).

The first metal layer 201a and the second metal layer 201b may be formed by a plating process. For example, the first metal layer 201a is formed thinly on the buffer layer 205. Next, the second metal layer 201b may be formed using the first metal layer 201a as a seed layer.

In addition, the bonding layer 203 may include a first bonding layer 203a and a second bonding layer 203b. The first bonding layer 203a is disposed on the metal layer 201. In detail, the first bonding layer 203a is disposed on the first connection wiring 211, the first pad 212a, and the second pad 212b. The second bonding layer 203b is disposed on the first bonding layer 203a. In detail, the second bonding layer 203b is disposed on the first pad 212a and the second pad 212b.

Therefore, the first connection wiring 211 includes a buffer layer 205, a metal layer 201, and a first bonding layer 203a. In addition, the first pad 212a and the second pad 212b include a buffer layer 205, a metal layer 201, a first bonding layer 203a, and a second bonding layer 203b.

Therefore, the layer structure of the first connection wiring 211 is different from the layer structures of the first pad 212a and the second pad 212b.

The first bonding layer 203a and the second bonding layer 203b include a metal. In detail, the first bonding layer 203a and the second bonding layer 203b may include tin (Sn).

The first bonding layer 203a and the second bonding layer 203b are disposed with different thicknesses. In detail, the thickness of the second bonding layer 203b is greater than the thickness of the first bonding layer 203a.

For example, the first bonding layer 203a has a thickness of 0.02 µm to 0.06 µm. In addition, the second bonding layer 203b has a thickness of 0.2 µm to 0.6 µm.

Therefore, a thickness of the first connection wiring 211 becomes thin. Therefore, when the flexible circuit board is bent, cracking of the first connection wiring 211 can be prevented.

A thickness of the first wiring pattern may be 2 µm to 25 µm. In detail, the thickness of the first wiring pattern may be 5 µm to 20 µm. In detail, the thickness of the first wiring pattern may be 7 µm to 15 µm.

If the thickness of the first wiring pattern is less than 2µm, the resistance of the first wiring pattern may increase. When the thickness of the first wiring pattern exceeds 25µm, it becomes difficult to implement a fine pattern.

Referring to FIGS. 21 to 25, the flexible circuit board may include a plurality of open regions.

The open regions may include a first open region OA1 and a second open region OA2. The first open region OA1 is formed on the first surface 1S. The second open region OA2 is formed on the second surface 2S.

The first open region OA1 is a region where the bonding layer 203 on the first surface 1S is not formed. The second open region OA2 is a region where the bonding layer 203 on the second surface 2S is not formed.

The first open region OA1 is formed on the third separation region IA3. The flexible circuit board is bent on the third separation region IA3. Accordingly, the third separation region IA3 includes the first bending region BA1. Accordingly, the first bending region BA1 is formed on the first open region OA1.

An outer surface of the first bending region BA1 is the first surface 1S. In addition, an inner surface of the first bending region BA1 is the second surface 2S. A tensile stress occurs on the outer surface of the first bending region BA1. Accordingly, the bonding layer 203 may be peeled off. Accordingly, the first open region OA1 is formed on the first surface 1S.

The second open region OA2 is formed on the first separation region IA1. The flexible circuit board is bent on the first separation region IA1. Accordingly, the first separation region IA1 includes the second bending region BA2. Accordingly, the second bending region BA2 is formed on the second open region OA2.

An outer surface of the second bending region BA2 is the second surface 2S. In addition, an inner surface of the second bending region BA2 is the first surface 1S. A tensile stress is generated on the outer surface of the second bending region BA2. Accordingly, the bonding layer 203 may be peeled off. Accordingly, the second open region OA1 is formed on the second surface 2S.

Stress occurs on the first bending region BA1 and the second bending region BA2. The bonding layer 203 is not disposed on the first open region OA1 and the second open region OA2. Therefore, the bonding layer 203 is not disposed on the first bending region BA1 and the second bending region BA2. Therefore, the bonding layer 203 can be prevented from being peeled off due to stress on the first bending region BA1 and the second bending region BA2.

Accordingly, the reliability of the flexible circuit board is improved. In addition, the curvature freedom of the first bending region BA1 and the second bending region BA2 increases. Therefore, the flexible circuit board can be bent at various curvatures.

Referring to FIGS. 22 and 23, the first protective layer 310 and the second protective layer 320 include a plurality of protective patterns.

The first protective layer 310 includes a first-first protective pattern 311 and a first-second protective pattern 312. The first-first protective pattern 311 is disposed inside the first open region OA1.

The first open region OA1 extends in the first direction 1D. Accordingly, the first-first protective pattern 311 extends in the first direction 1D. Accordingly, the first-first protective layer is disposed inside the first open region OA1 and on the second wiring pattern between the first open regions OA1. The first protective pattern 311 can be disposed to a thickness less than or equal to the thickness of the bonding layer 203.

The first-second protective pattern 312 is disposed on the first-first protective pattern 311. In detail, the first-second protective pattern 312 is disposed on the first-first protective pattern 311, the first wiring pattern, the second wiring pattern, and the first surface. The thickness of the first-second protective pattern 312 may be different from the thickness of the first-first protective pattern 311. For example, the thickness of the first-second protective pattern 312 may be greater than the thickness of the first-first protective pattern 311. That is, a distance from an uppermost surface of the first-second protective pattern 312 to the substrate may be greater than a distance from an uppermost surface of the first-first protective pattern 311 to the substrate.

Since the first protective layer 310 includes the first-first protective pattern 311 and the first-second protective pattern 312, two protective patterns may be disposed on the first open region OA1. Therefore, the first-first protective layer 310 may be prevented from being peeled off due to stress on the first bending region BA1.

Accordingly, the reliability of the flexible circuit board is improved. In addition, the degree of curvature freedom of the first bending region BA1 is increased. Therefore, the flexible circuit board can be bent at various curvatures.

The second protective layer 320 includes a second-first protective pattern 321 and a second-second protective pattern 322. The second-first protective pattern 321 is disposed inside the second open region OA1.

The second open region OA2 extends in the first direction 1D. Accordingly, the second-first protective pattern 321 extends in the first direction 1D. Accordingly, the second-first protective layer is disposed inside the second open region OA2 and on the second wiring pattern between the second open regions OA2. The second-first protective pattern 321 can be disposed to a thickness less than or equal to a thickness of the bonding layer 203.

The second-second protective pattern 322 is disposed on the second-first protective pattern 321. In detail, the second-second protective pattern 312 is disposed on the second-first protective pattern 321, the second wiring pattern, the third wiring pattern, and the second surface. The thickness of the second-second protective pattern 322 may be different from the thickness of the second-first protective pattern 321. For example, the thickness of the second-second protective pattern 322 may be greater than the thickness of the second-first protective pattern 321. That is, a distance from an uppermost surface of the second-second protective pattern 322 to the substrate may be greater than a distance from an uppermost surface of the second-first protective pattern 321 to the substrate.

Since the second protective layer 320 includes the second-first protective pattern 321 and the second-second protective pattern 322, two protective patterns may be disposed on the second open region OA2. Accordingly, the second protective layer 320 can be prevented from being peeled off due to stress on the second bending region BA1.

Accordingly, the reliability of the flexible circuit board is improved. In addition, the degree of curvature freedom of the second bending region BA2 increases. Therefore, the flexible circuit board can be bent at various curvatures.

Referring to FIG. 24 and FIG. 25, the first protective layer 310 or the second protective layer 320 can include a plurality of protective layers.

Referring to FIG. 24, the first protective layer 310 includes a first-first protective pattern 311 and a first-second protective pattern 312. In addition, the second protective layer 320 includes only one protective pattern.

Referring to FIG. 25, the second protective layer 320 includes a second-first protective pattern 321 and a second-second protective pattern 322. In addition, the first protective layer 310 includes only one protective pattern.

For example, a curvature of the first bending region BA1 may be greater than a curvature of the second bending region BA2. Accordingly, the stress on the first bending region BA1 may be greater than the stress on the second bending region BA2. In this case, the first protective layer 310 may include a first-first protective pattern 311 and a first-second protective pattern 312. Accordingly, the first protective layer 310 on the first bending region BA1 can be prevented from being peeled off.

Alternatively, a curvature of the second bending region BA2 can be greater than a curvature of the first bending region BA1. Accordingly, the stress on the second bending region BA2 can be greater than the stress on the first bending region BA1. In this case, the second protective layer 320 can include the second-first protective pattern 321 and the second-second protective pattern 322. Accordingly, the second protective layer 320 on the second bending region BA2 can be prevented from being peeled off.

A thickness T1 of the first protective layer 310 and a thickness T2 of the second protective layer 320 can be the same or similar. Accordingly, weights of the protective layers disposed on the first surface 1S and the second surface 2S can be similar. Therefore, the flexible circuit board is prevented from being bent in one direction before being bent.

The thickness T1 of the first protective layer 310 and the thickness T2 of the second protective layer 320 may be different. For example, the thickness T2 of the second protective layer 320 may be greater than the thickness T1 of the first protective layer 310. Alternatively, the thickness T1 of the first protective layer 310 may be greater than the thickness T2 of the second protective layer 320.

The flexible circuit board may be bent two or more times on the first separation region IA1. Therefore, the stress on the first surface 1S and the stress on the second surface 2S may be different. For example, the stress on the first surface 1S may be greater than the stress on the second surface 2S. In this case, the thickness T1 of the first protective layer 310 is made larger than the thickness T2 of the second protective layer 320. Alternatively, the stress on the second surface 2S may be larger than the stress on the first surface 1S. In this case, the thickness T2 of the second protective layer 320 is made larger than the thickness T1 of the first protective layer 310.

Therefore, the protective layer on the surface where the stress is greatly generated becomes thicker. Accordingly, when the flexible circuit board is bent, the first protective layer or the second protective layer can be prevented from being peeled off.

In FIGS. 21 to 25, one bonding layer is illustrated as being disposed. However, the embodiment is not limited thereto. The bonding layer may include the first bonding layer 203a and the second bonding layer 203b.

At least one of the first bonding layer 203a and the second bonding layer 203b may not be disposed on the open region OA1 and OA2.

In detail, the second bonding layer 203b may not be disposed on the open region OA1 and OA2. Alternatively, both the first bonding layer 203a and the second bonding layer 203b may be disposed on the open region OA1 and OA2. Alternatively, the second bonding layer 203b may not be disposed in one open region, and both the first bonding layer 203a and the second bonding layer 203b may not be disposed in the other open region.

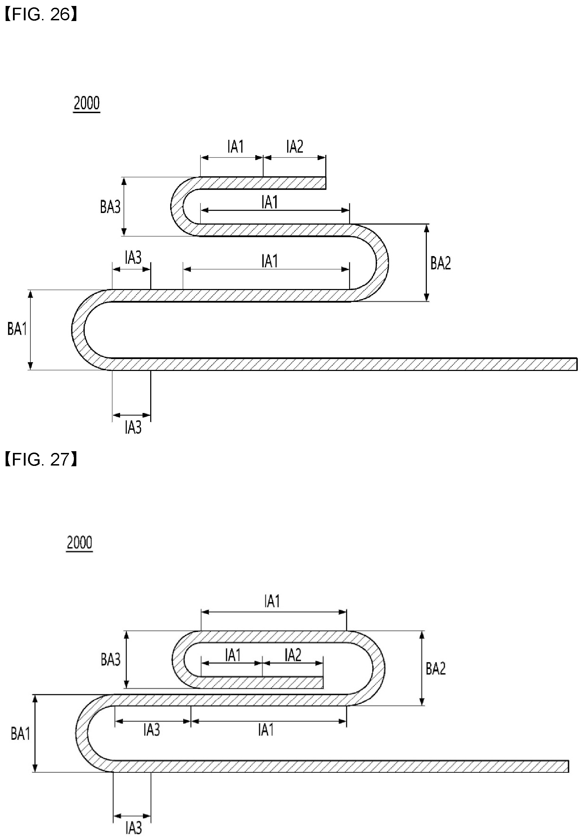

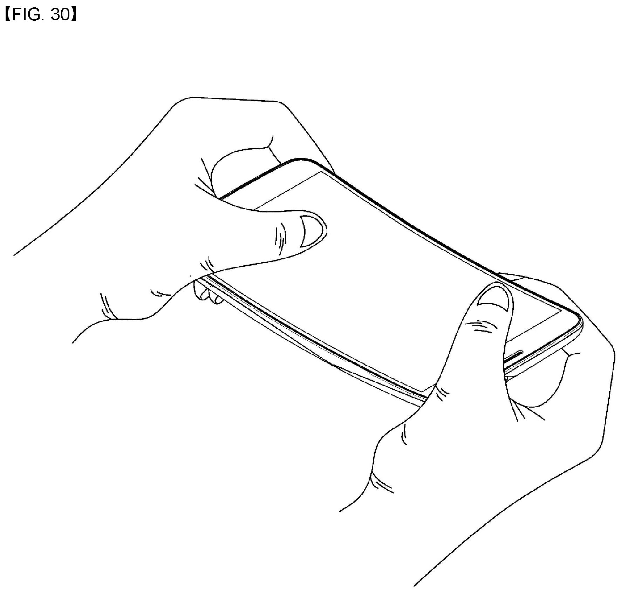

FIG. 26 to FIG. 29 are views illustrating various shapes in which a COF module including a flexible circuit board according to an embodiment is bent, and FIG. 30 to FIG. 32 are views regarding an electronic device including a flexible circuit board according to an embodiment.

FIGS. 26 to 29 are drawings illustrating various shapes in which a COF module is bent according to an embodiment.

Referring to FIGS. 26 to 29, the COF module 2000 can be bent at least three times. For example, referring to FIGS. 26 to 27, the COF module 2000 can be bent three times. That is, the COF module 2000 can include a first bending region BA1, a second bending region BA2, and a third bending region BA3.

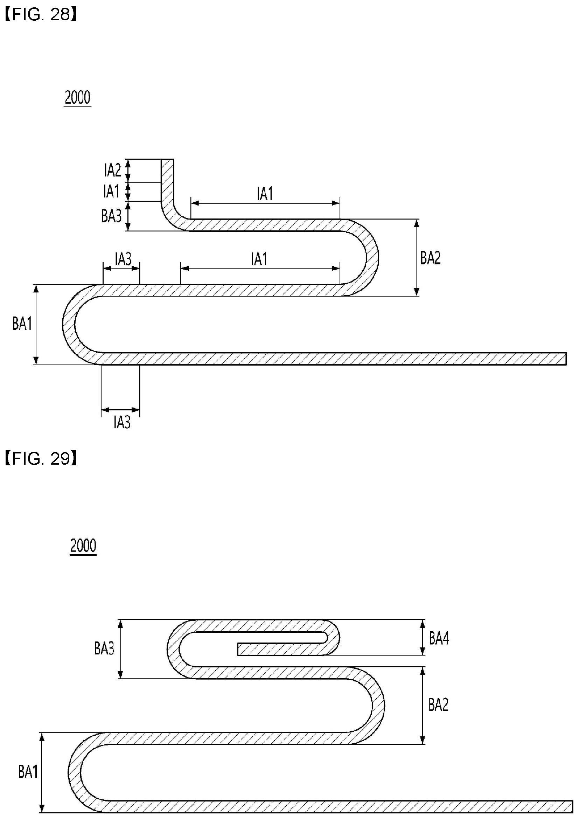

Referring to FIGS. 26 and 28, the first bending region BA1 is formed on the third separation region IA3. The second bending region BA2 and the third bending region BA3 are formed on the first separation region IA1. Therefore, a plurality of second open regions can be formed on the first separation region IA1. For example, a second-first open region and a second-second open region may be formed on the first separation region IA1.

The second bending region BA2 is bent so that the second surface 2S becomes the outer surface. The third bending region BA3 is bent so that the first surface 1S becomes the outer surface. Therefore, the second-first open region and the second-second open region are formed on different surfaces. In detail, the second-first open region is formed on the second surface 2S, and the second-second open region is formed on the first surface 1S.

Referring to FIG. 27, the first bending region BA1 is formed on the third separation region IA3. The second bending region BA2 and the third bending region BA3 are formed on the first separation region IA1. Therefore, a plurality of second open regions may be formed on the first separation region IA1. For example, a second-first open region and a second-second open region may be formed on the first separation region IA1.

The second bending region BA2 is bent so that the second surface 2S becomes the outer surface. The third bending region BA3 is bent so that the second surface 2S becomes the outer surface. Therefore, the second-first open region and the second-second open region are formed on a same surface. In detail, the second-first open region and the second-second open region are formed on the second surface 2S.

Referring to FIG. 29, the COF module 2000 may be bent four times. That is, the COF module 2000 may include a first bending region BA1, a second bending region BA2, a third bending region BA3, and a fourth bending region BA4.

The first bending region BA1 is formed on the third separation region IA3. The second bending region BA2, the third bending region BA3, and the fourth bending region BA4 are formed on the first separation region IA1. Therefore, a plurality of second open regions can be formed on the first separation region IA1. For example, the second-first open region, the second-second open region, and the second-third open region can be formed on the first separation region IA1.

The second bending region BA2 is bent so that the second surface 2S becomes the outer surface. The third bending region BA3 is bent so that the first surface 1S becomes the outer surface. The fourth bending region BA4 is bent so that the first surface 1S becomes the outer surface. Therefore, the second-first open region, the second-second open region, and the second-third open region are formed on different surfaces. In detail, the second-first open region is formed on the second surface 2S. In addition, the second-second open region and the second-third open region are formed on the first surface 1S.

The first separation region IA1 and the third separation region IA3 can be bent with the same or different curvatures. For example, referring to FIG. 22, the first separation region IA1 and the third separation region IA3 can be bent with different curvatures.

A chip CH is mounted on a flexible circuit board according to an embodiment. Then, it is cut along a cutting line CL. As a result, a COF module is manufactured.

The COF module 2000 can transmit an electrical signal by connecting a display panel 4000 and a circuit board 3000.

One end of the COF module 2000 is connected to the display panel 4000. The other end of the COF module 2000 is connected to the circuit board 3000. For example, the display panel 4000 is disposed on one surface of the COF module 2000. In addition, the circuit board 3000 is disposed on the other surface of the COF module 2000.

The COF module 2000 includes a flexible substrate. Accordingly, it can have both a rigid form and a bent form between the display panel 3000 and the circuit board 4000.

The COF module 2000 can be connected in a bent form between the display panel 4000 and the circuit board 3000 which are disposed opposite each other. Therefore, a thickness of the electronic device is reduced. In addition, the design freedom of the electronic device is improved. In addition, the COF module 2000 does not have wiring break even in a bent form. Accordingly, the reliability of the electronic device is improved.

In addition, since the COF module 2000 is bent in the first separation region IA1, a bezel region of the display panel 4000 is reduced. In addition, since the COF module 2000 is not bent in the second separation region IA1, deformation of the via can be prevented. In addition, the COF module 2000 has at least one second open region formed on the first separation region IA1. Accordingly, when the flexible circuit board is bent, the bonding layer and the protective layer are prevented from being peeled off.

Since the COF module is flexible, it is applied to various electronic devices.

Referring to FIG. 30, the COF module can be applied to a flexible touch window that can be bent. Therefore, a touch device including the COF can be a flexible touch device.

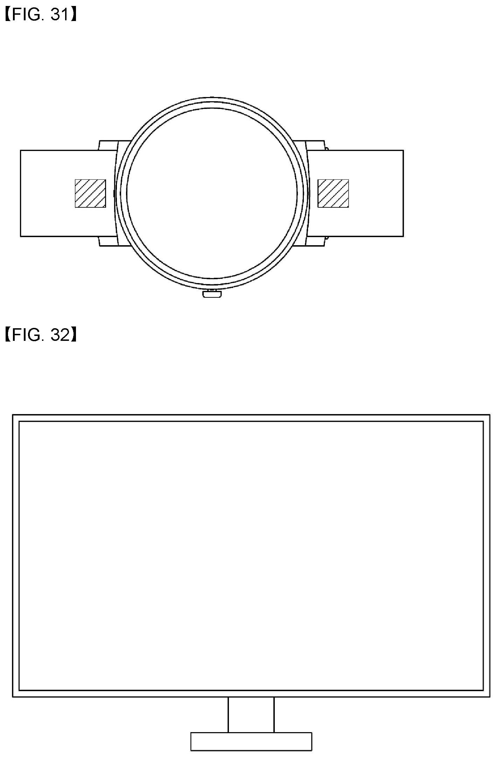

Referring to FIG. 31, the COF module can be applied to various wearable touch devices including a curved display. Therefore, the wearable touch device can be slimmed down or made lightweight.

Referring to FIG. 32, the COF module can be applied to various electronic devices having a display portion, such as a TV, a monitor, and a laptop.

The characteristics, structures, effects, and the like described in the above-described embodiments are included in at least one embodiment of the present invention, but are not limited to only one embodiment. Furthermore, the characteristic, structure, and effect illustrated in each embodiment may be combined or modified for other embodiments by a person skilled in the art. Accordingly, it is to be understood that such combination and modification are included in the scope of the present invention.

In addition, embodiments are mostly described above, but the embodiments are merely examples and do not limit the present invention, and a person skilled in the art may appreciate that several variations and applications not presented above may be made without departing from the essential characteristic of embodiments. For example, each component specifically represented in the embodiments may be varied. In addition, it should be construed that differences related to such a variation and such an application are included in the scope of the present invention defined in the following claims.

## Claims

1. A flexible circuit board comprising:
a substrate;
an upper wiring pattern disposed on the substrate;
an upper protective layer disposed on the upper wiring pattern and including an open region;
a lower wiring pattern disposed under the substrate; and
a lower protective layer disposed under the lower wiring pattern,
wherein the upper wiring pattern includes a first overlapping region overlapping the upper protective layer along a thickness direction of the substrate,
wherein the lower wiring pattern includes a second overlapping region overlapping the lower protective layer along the thickness direction of the substrate, and
wherein a metal content of the upper wiring pattern in the first overlapping region is different from a metal content of the lower wiring pattern in the second overlapping region.

2. The flexible circuit board of claim 1, wherein the first overlapping region includes a region in which a content of a metal constituting the upper wiring pattern changes as it approaches the upper protective layer, and
wherein the second overlapping region does not include a region in which a content of a metal constituting the lower wiring pattern changes.

3. The flexible circuit board of claim 1, wherein an amount of change in the content of the metal constituting the upper wiring pattern in the first overlapping region as the upper wiring pattern approaches the upper protective layer is greater than an amount of change in the content of the metal constituting the lower wiring pattern in the second overlapping region as the lower wiring pattern approaches the lower protective layer

4. The flexible circuit board of claim 1, wherein the upper wiring pattern includes an upper wiring layer disposed on the substrate, a first upper plating layer disposed on the upper wiring layer; and a second upper plating layer disposed on the first upper plating layer within the open region,
wherein the lower wiring pattern includes a lower wiring layer disposed under the substrate,
wherein the upper protective layer is in direct contact with the first upper plating layer in the first overlapping region, and
wherein the lower protective layer is in direct contact with the lower wiring layer in the second overlapping region.

5. The flexible circuit board of claim 4, wherein the first upper plating layer includes an open portion overlapping at least a portion of the upper wiring layer along the thickness direction, and
wherein the upper protective layer includes a first protective pattern disposed in the open portion of the first upper plating layer, and a second protective pattern disposed on the first upper plating layer and the first protective pattern.

6. The flexible circuit board of claim 5, wherein the upper protective layer includes a first open region positioned between a first side end and a second side end of the substrate, and a second open region spaced from the first open region and closer to the first side end than the first open region, and
wherein the open portion of the first upper plating layer is closer to the second side end of the substrate than the first open region and the second open region.

7. The flexible circuit board of claim 6, wherein the lower protective layer includes a third open region closer to the second side end of the substrate than the first open region and the second open region, and
wherein the lower wiring pattern further includes a first lower plating layer disposed under the lower wiring layer in the third open region, and a second lower plating layer disposed under the first lower plating layer.

8. The flexible circuit board of claim 6, wherein the upper protective layer includes a third open region closer to the second side end of the substrate than the first open region and the second open region,
wherein the lower protective layer does not include an open region, and
wherein the lower surface of the lower wiring layer of the lower wiring pattern is in direct contact with the lower protective layer as a whole.

9. The flexible circuit board of claim 7 or 8, further comprising:
a first via electrode penetrating the substrate along the thickness direction at a position adjacent to the first open region and connecting the upper wiring pattern and the lower wiring pattern; and
a second via electrode penetrating the substrate along the thickness direction at a position adjacent to the third open region and connecting the upper wiring pattern and the lower wiring pattern, and
wherein the open portion of the first upper plating layer is provided to extend in a direction different from a separation direction of the first via electrode and the second via electrode between the first via electrode and the second via electrode.

10. The flexible circuit board of claim 6, wherein the lower wiring pattern does not overlap with a region between the first open region and the second open region along the thickness direction.
